(19) Europäisches Patentamt
European Patent Office
Office européen des brevets

(11) EP 4 556 900 A1

(12) EUROPEAN PATENT APPLICATION
published in accordance with Art. 153(4) EPC

(43) Date of publication:
21.05.2025 Bulletin 2025/21

(21) Application number: 23837940.8

(22) Date of filing: 11.07.2023

(51) International Patent Classification (IPC):
G01N 27/48 (2006.01)     G01N 27/327 (2006.01)
G01N 27/12 (2006.01)     H10N 30/80 (2023.01)
H10N 30/30 (2023.01)     H01L 31/0264 (2006.01)
H01L 31/02 (2006.01)     H01L 31/0224 (2006.01)
H01L 31/028 (2006.01)     H01L 31/102 (2006.01)

(52) Cooperative Patent Classification (CPC):
G01N 27/12; G01N 27/327; G01N 27/48;
H10F 30/22; H10F 77/00; H10F 77/12;
H10F 77/122; H10F 77/20; H10N 30/30;
H10N 30/80

(86) International application number:
PCT/KR2023/009811

(87) International publication number:
WO 2024/014820 (18.01.2024 Gazette 2024/03)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 12.07.2022  KR 20220085886
04.11.2022  KR 20220146383
23.11.2022  KR 20220158437
15.05.2023  KR 20230062520

(71) Applicant: A Barristor Company
Seoul 05029 (KR)

(72) Inventors:
• CHUNG, Hyun Jong
Osan-si Gyeonggi-do 18107 (KR)
• JEONG, Nae Bong
Seoul 05057 (KR)
• LEE, Sun Min
Seoul 05043 (KR)

(74) Representative: Impuls legal PartG mbB
Goethestraße 21
80336 München (DE)

(54) **GRAPHENE-BASED SENSOR, MEASUREMENT DEVICE USING SAME, SPECIMEN MEASUREMENT METHOD, AND SPECIMEN ANALYSIS METHOD**

(57) A graphene-based sensor, a measurement device using the same, and a method of measuring and analyzing a specimen are provided. The graphene-based sensor according to an embodiment of the present disclosure includes a substrate, a doped region formed by doping a partial region of the substrate with impurities, an insulator layer stacked on the substrate except for a portion of the doped region, a graphene layer stacked on the doped region, a first electrode connected to the graphene layer, and a second electrode connected to the doped region.

FIG. 1A

**Description**

TECHNICAL FIELD

The present disclosure relates to a graphene-based sensor, a measurement device using the same, and a method of measuring and analyzing a specimen.

BACKGROUND

There are various types of sensors, such as biosensors for detecting biomaterials such as enzymes, antibodies, and DNA, gas sensors for detecting gas concentrations, etc., and pressure sensors for detecting pressure. Among the sensors, the biosensors are largely classified into optical method-based biosensors, electrochemical method-based biosensors, and piezoelectric method-based biosensors. The optical method-based biosensors use an optical method such as color development, fluorescence, chemiluminescence, and surface plasmon resonance, and the electrochemical method-based biosensors use a method of measuring the interaction between an analyte and a bioreceptor by using an electrochemical signal, such as a potential, current, charge amount, conductivity, and impedance. The piezoelectric method-based biosensors use a method of measuring a mass change. The electrochemical method-based biosensors have advantages over other methods in terms of portability and miniaturization. In addition, the electrochemical method-based biosensors facilitate a signal conversion process compared to the optical method-based biosensors since they are available in both labeled and non-labeled methods and employ an electrical signal for a detection signal. The electrochemical method-based sensors may be implemented based on a transistor in order to accurately measure a change in a minute electrical signal.

As a new material that can replace semiconductors, graphene is being actively studied. Graphene has two-dimensional planar crystal structure having a hexagonal honeycomb shape, and is used in various fields due to the thinness and lightness and excellent durability and conductivity thereof. Recently, a new element functionally close to a transistor but structurally close to a diode, that is, a barristor, has emerged using graphene.

SUMMARY

An aspect of the present disclosure is to provide a graphene-based sensor capable of detecting minute changes in electrical signals exhibited by a specimen.

Another aspect of the present disclosure is to provide a measurement device using a graphene-based sensor.

Another aspect of the present disclosure is to provide a method of measuring a specimen by applying a voltage to a sensor.

Another aspect of the present disclosure is to provide a method of analyzing a measurement value of a sensor array including a plurality of graphene-based sensors by using an artificial neural network.

The technical problems of the disclosure are not limited to the technical problems mentioned above, and other technical problems that are not mentioned will be clearly understood by those of ordinary skill in the art to which the disclosure belongs from the following description.

A graphene-based sensor according to an embodiment of the present disclosure includes a substrate, a doped region formed by doping a partial region of the substrate with impurities, an insulator layer stacked on the substrate except for a portion of the doped region, a graphene layer stacked on the doped region, a first electrode connected to the graphene layer, and a second electrode connected to the doped region.

In an embodiment, the doped region may include a first doped region doped to have a first concentration, and a second doped region doped to have a second concentration, wherein the first concentration is equal to or less than the second concentration, wherein the graphene layer is connected to the first doped region, and wherein the second electrode is connected to the second doped region.

In an embodiment, the first electrode may surround a periphery of the graphene layer.

In an embodiment, the second electrode may be positioned under the substrate to be opposite to the graphene layer.

In an embodiment, the graphene-based sensor may further include one or more via electrodes passing through the insulator layer and the substrate from a position spaced apart from the first electrode, wherein the second electrode may be connected to the one or more via electrodes.

In an embodiment, the second electrode may pass through the insulator layer to be connected to the doped region.

In an embodiment, the graphene-based sensor may further include a third electrode spaced apart from the first electrode and in contact with the graphene layer.

In an embodiment, the graphene-based sensor may further include a storage unit formed by etching the substrate to have a first depth and a first width, and a channel unit formed by etching the insulator layer to have a second depth and a second width and configured to connect the storage unit and the graphene layer to each other, wherein the second depth and the second width are smaller than the first depth and the first width, respectively.

In an embodiment, a plurality of doped regions may be formed on the substrate to be spaced apart from each other, and wherein the insulator layer may be stacked such that the plurality of doped regions are exposed.

In an embodiment, the graphene layer is stacked to correspond to the plurality of doped regions , wherein the graphene-based sensor includes a plurality of first electrodes corresponding to the plurality of doped regions, respectively and wherein the second electrode is connected in common to the plurality of doped regions.

In an embodiment, the graphene layer is stacked on the plurality of doped regions, wherein the graphene-based sensor includes a plurality of second electrodes connected to the plurality of doped regions, respectively and wherein the first electrode is connected in common to the plurality of doped regions.

In an embodiment, the graphene-based sensor may further include a multiplexer configured to output a value measured through the graphene layer on the plurality of doped regions.

In an embodiment, the graphene-based sensor may further include a reaction layer located on a surface of the graphene layer and including a material that induces electric charges in the graphene layer.

A graphene-based sensor according to another embodiment of the present disclosure may include a substrate, a two-dimensional semiconductor layer stacked on the substrate, a graphene layer stacked on the two-dimensional semiconductor layer, and a first electrode stacked in contact with the two-dimensional semiconductor layer, and a second electrode stacked in contact with the graphene layer.

In another embodiment, the graphene-based sensor may include a reaction layer located on a surface of the graphene layer and including a material that induces electric charges in the graphene layer.

In another embodiment, a plurality of two-dimensional semiconductor layers are disposed on the substrate to be spaced apart from each other, wherein the graphene layer is stacked on the plurality of two-dimensional semiconductor layers, and wherein a plurality of first electrodes are disposed on the plurality of two-dimensional semiconductor layers, respectively.

In another embodiment, a two-dimensional material constituting the plurality of two-dimensional semiconductor layers may include a portion and another portion different from each other.

In another embodiment, the plurality of two-dimensional semiconductor layers may be disposed in a first direction, and wherein the graphene layer may be disposed in a second direction perpendicular to the first direction.

In another embodiment, the graphene-based sensor may further include a third electrode spaced apart from the first electrode and stacked in contact with the two-dimensional semiconductor layer.

In another embodiment, the graphene-based sensor may further include a fourth electrode spaced apart from the second electrode and stacked in contact with the graphene layer.

In another embodiment, the graphene-based sensor may further include a third electrode connected in common to a plurality of two-dimensional semiconductor layers, wherein the plurality of two-dimensional semiconductor layers are radially arranged, wherein the graphene layer is disposed across the plurality of two-dimensional semiconductor layers to have a circular band shape, wherein a plurality of first electrodes are connected to the plurality of two-dimensional semiconductor layers, and wherein the plurality of first electrodes are connected to the plurality of two-dimensional semiconductor layers, respectively.

A measurement device according to another embodiment of the present disclosure may include a graphene-based sensor in which a graphene layer is stacked on a doped region formed on a substrate or on a two-dimensional semiconductor layer stacked on a substrate, and an output unit configured to convert an output current of the graphene-based sensor into a voltage and output the voltage.

In another embodiment, the output unit may include: a preamplification unit configured to convert the output current of the graphene-based sensor into a voltage and output the voltage; and a feedback unit configured to perform adjustment such that the output voltage of the preamplification unit is in a predetermined range.

In another embodiment, the measurement device may further include a display unit configured to display the output voltage of the output unit, and a communication unit configured to transmit an output voltage of the output unit to the outside.

In another embodiment, the measurement device may include a sensor array in which the graphene-based sensor is arranged in one or two dimensions, and a multiplexer connected to a plurality of graphene-based sensors constituting the sensor array, wherein the output unit is configured to selectively receive an output current of each graphene-based sensor through the multiplexer.

In another embodiment, the measurement device may further include an internal circuit including a mapping table set corresponding to an artificial neural network that receives a measurement value obtained by a reaction between a specimen and a material of a reaction layer of the graphene-based sensor, and outputs an analysis value.

In another embodiment, the measurement device may further include a voltage application unit configured to apply a voltage within a predetermined range to the graphene-based sensor, and a measurement unit configured to detect a first measurement value of resistance or current of the graphene-based sensor according to a voltage applied before application of a specimen, and detect and output a second measurement value of resistance or current of the graphene-based sensor according to a voltage applied after application of the specimen.

In another embodiment, the measurement unit may output a result value including a maximum difference among voltage-specific differences between the first measurement value and the second measurement value.

In another embodiment, the measurement unit may repeat a process of measuring the second measurement value at regular time intervals, and output a second measurement value of resistance or current of the sensor according to a voltage applied whenever a repetition is performed.

In another embodiment, the measurement unit may detect and output a change in a maximum difference between the first measurement value and the second measurement value whenever the repetition is performed.

According to another embodiment of the present disclosure, an analysis method using a sensor array including a plurality of sensors in which a graphene layer is stacked on a two-dimensional semiconductor or on a semiconductor region doped on a substrate, the method including receiving a plurality of measurement values from a plurality of graphene-based sensors of the sensor array; and receiving the plurality of measurement values and obtaining an analysis result, by an artificial neural network using an arithmetic operation determined in a mapping table set.

In another embodiment, a material of a reaction layer applied on a graphene layer of the plurality of graphene-based sensors may include a portion and another portion different from each other.

In another embodiment, a material of a reaction layer of the plurality of graphene-based sensors may be at least one of a quantum dot, a biomolecule, a gas-responsive molecule, or a pressure-responsive structure.

A graphene-based sensor according to the present disclosure has higher reaction sensitivity than general sensors, and thus can accurately measure changes in minute electrical signals caused by interactions between antigens, antibodies, enzymes, DNA, and the like. In addition, the graphene-based sensor can be applied not only to the bio field, but also to various fields requiring measurement of light, gas, pressure, etc.

According to the present disclosure, a specimen can be accurately measured using a sensor. The accuracy of measurement can be improved based on the difference between the sensor values measured before and after application of a specimen.

According to the present disclosure, the measurement sensitivity of a specimen can be improved using a graphene-based sensor.

The effects according to the technical idea of the present disclosure are not limited to the effects mentioned above, and other effects that are not mentioned will be clearly understood by those of ordinary skill in the art to which the disclosure belongs from the following description.

BRIEF DESCRIPTION OF DRAWINGS

FIGS. 1A to 1D illustrate structures of a graphene-based sensor according to a first embodiment of the present disclosure.

FIGS. 2A to 2D illustrate structures of a graphene-based sensor according to a second embodiment of the present disclosure.

FIGS. 3A to 3B illustrate structures of a graphene-based sensor according to a third embodiment of the present disclosure.

FIGS. 4A to 4B illustrate structures of a graphene-based sensor according to a fourth embodiment the present disclosure.

FIG. 5 illustrates a structure of a graphene-based sensor according to a fifth embodiment the present disclosure.

FIGS. 6A to 6B illustrate structures of a sensor array according to a first embodiment of the present disclosure.

FIGS. 7A to 7D illustrate structures of a sensor array according to a second embodiment of the present disclosure.

FIGS. 8A to 8D illustrate structures of a sensor array according to a third embodiment of the present disclosure.

FIGS. 9A to 9B illustrate structures of a sensor array according to a fourth embodiment of the present disclosure.

FIGS. 10A to 10B illustrate structures of a sensor array according to a fifth embodiment of the present disclosure.

FIGS. 11A to 11B illustrate a structure of a sensor array according to a sixth embodiment of the present disclosure.

FIG. 12 illustrates a structure of a sensor array according to a seventh embodiment of the present disclosure.

FIGS. 13A to 13B illustrate a structure of a sensor array according to an eighth embodiment of the present disclosure.

FIG. 14 illustrates a structure of a sensor array according to a ninth embodiment of the present disclosure.

FIG. 15 illustrates a structure of a sensor array according to a tenth embodiment of the present disclosure.

FIGS. 16A and 16B illustrate examples of a change in current of a graphene-based sensor according to the present disclosure.

FIGS. 17 and 18 illustrate various examples of a measurement device using a graphene-based sensor according to the present disclosure.

FIG. 19 illustrates an example of a detailed configuration of a feedback unit and a controller of a measurement device according to the present disclosure.

FIGS. 20 to 26 illustrate various examples of a measurement device using a sensor array according to the present disclosure.

FIG. 27 illustrates a block diagram of a measurement device according to the present disclosure.

FIGS. 28 to 29 illustrate implementation examples of a measurement device according to the present disclosure.

FIG. 30 is a flowchart illustrating a method of measuring a specimen according to the present disclosure.

FIG. 31 illustrates an example of a method of applying a buffer solution that may be referred to in various embodiments of the present disclosure.

FIG. 32 illustrates an example of a method of measuring a specimen according to the present disclosure.

FIG. 33 illustrates an example of measurement results that may be referred to in various embodiments of the present disclosure.

FIG. 34 illustrates an example of usage of a measurement device according to the present disclosure.

FIG. 35 illustrates an example of a method of analyzing a measurement result according to the present disclosure.

FIG. 36 illustrates an example of an artificial neural network that may be referred to in various embodiments of the present disclosure.

DETAILED DESCRIPTION

Various embodiments of the present disclosure are illustrated for clearly explaining the technical spirit of the present disclosure, and are not intended to be limited to specific embodiments. The technical spirit of the present disclosure includes various modifications, equivalents, and alternatives of each embodiment described in the present disclosure, and embodiments selectively combined from all or part of each embodiment. In addition, the scope of the technical idea of the present disclosure is not limited to the various embodiments or specific descriptions thereof presented below.

All technical or scientific terms used herein have meanings that are generally understood by a person having ordinary knowledge in the art to which the present disclosure pertains, unless otherwise specified.

The expressions such as "comprise," "may comprise," "include," "may include," "have," "may have," etc. used in the present disclosure refer to the presence of any stated features (e.g., function, operation, or element), and do not preclude the presence of other additional features. That is, such expressions should be understood as open-ended terms that include the possibility of including other embodiments.

A singular expression may include meanings of plurality unless otherwise mentioned, and the same is applied to a singular expression stated in the claims.

The terms "first," "second," etc. used herein are used to identify a plurality of elements of the same kind from one another, and are not intended to limit the order or importance of the relevant elements.

As used in the present disclosure, expressions such as "A, B, and C," "A, B, or C," "at least one of A, B, and C," or "at least one of A, B, or C" refer to each listed item or all possible combinations of listed items. For example, "at least one of A or B" may refer to all (1) at least one A, (2) at least one B, and (3) at least one A and at least one B.

As used in this disclosure, the expression "based on" is used to describe one or more factors that influence the action or operation of a decision and judgment, described in a phrase or sentence including the expression, and the expression does not exclude additional factors that may influence the action or operation of the decision and judgment.

As used in the present disclosure, the expression that an element (e.g., a first element) is "coupled" or "connected" to another element (e.g., a second element) may mean not only being directly coupled or connected to another element, but also being coupled or connected through another new element (e.g., a third element).

The expression "configured to" as used in this disclosure may have meanings such as "configured to," "having the ability to," "modified to," "made to," and "to do ~," depending on the context. This expression is not limited to the meaning of "specifically designed in hardware," and for example, a processor configured to perform a specific operation may mean a generic purpose processor capable of performing the specific operation by executing software, or a special purpose computer structured through programming to perform the specific operation.

The term "~ unit" used in the present disclosure means a software element or a hardware element such as a Field-Programmable Gate Array (FPGA) or Application Specific Integrated Circuit (ASIC). However, "~ unit" is not limited to hardware and software, and "~ unit" may be configured to be in an addressable storage medium or configured to reproduce one or more processors. Thus, as examples of what may be indicated by "~ unit," the "~ unit" includes elements, such as software elements, object-oriented software elements, class elements, and task elements, processors, functions, properties, procedures, subroutines, segments of program code, drivers, firmware, microcode, circuits, data, databases, data structures, tables, arrays, and variables. In addition, functions provided within elements and "~unit" may be combined to be fewer elements and "~unit" or further separated into additional elements and "~unit."

The term "artificial intelligence (AI)" used in the present disclosure may refer to a technology that imitates human learning, reasoning, or perception abilities and implement them as a computer. Specifically, artificial intelligence can perform judgments or predictions based on input data by analyzing input data and generating output data based on the results of the analysis. In addition, artificial intelligence may perform techniques that mimic cognitive or judgmental functions (e.g., linguistic understanding, visual understanding, reasoning/prediction, knowledge expression or motion control, etc.) of human brain. In one embodiment, artificial intelligence may include the concept of machine learning or symbolic logic.

The term "machine learning (ML)" used in the present disclosure may refer to a series of processes for training an artificial neural network model by using data processing experience. Through such machine learning, artificial neural network models can improve data processing capabilities thereof.

The term "artificial neural network model" used in the present disclosure is constructed by modeling a correlation between data, and the correlation may be expressed by a plurality of parameters. Such an artificial neural network model may be implemented on a computer to include a plurality of network nodes having weights and simulating a human brain structure, for example, neurons of a human neural network. The artificial neural network model may optimize parameters of the artificial neural network model by repeating a series of operations of extracting features from given training data, analyzing the extracted features, and deriving a correlation between data. Optimizing the parameters of an artificial neural network model in this way can be referred to as machine learning. As a specific example, an artificial neural network model may learn a mapping (correlation) between an input and an output with respect to data given as an input/output pair, and this may be referred to as supervised learning. As another example, even when only input data is given, an artificial neural network model may learn a relationship by deriving a regularity between given data, which may be referred to as unsupervised learning. An artificial neural network model in the present disclosure may be interchangeably referred to as an "artificial neural network," "model," "neural network model," "artificial intelligence learning model," or "machine learning model."

Hereinafter, various embodiments described in the present disclosure will be described with reference to the accompanying drawings. In the accompanying drawings and description of the drawings, identical or substantially equivalent elements may be given the same reference numerals. In addition, in the following description of various embodiments, overlapping descriptions of the same or corresponding elements may be omitted, but this does not mean that the elements are not included in the embodiments.

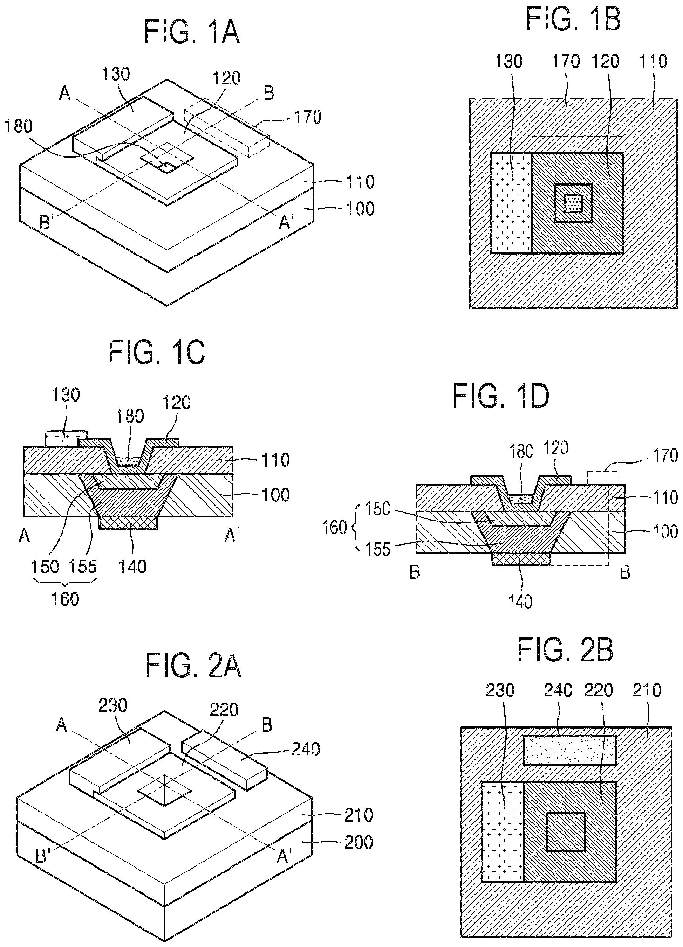

FIGS. 1A to 1D illustrate structures of a graphene-based sensor according to a first embodiment of the present disclosure. Specifically, FIG. 1A is a perspective view of the graphene-based sensor in the first embodiment, FIG. 1B is a plan view of the graphene-based sensor in the first embodiment, FIG. 1C is a cross-sectional view taken along line A-A' of the graphene-based sensor of the first embodiment in FIG. 1A, and FIG. 1D is a cross-sectional view taken along line B-B' of the graphene-based sensor of the first embodiment in FIG. 1A. The term "FIG. 1" may refer to any one of FIGS. 1A to 1D.

Referring to FIG. 1, the graphene-based sensor includes a substrate 100, an insulator layer 110, a graphene layer 120, a first electrode 130, a second electrode 140, and a doped region 160.

The doped region 160 including impurities doped therein exists in the substrate 100. In an embodiment, the substrate may be a semiconductor layer made of a general semiconductor material, such as silicon, germanium, or a compound semiconductor. The doped region 160 may be doped with n-type impurities or p-type impurities. In an embodiment, the doped region 160 may include two regions 150 and 155 having different doping concentrations. For example, the doped region 160 may include the first doped region 150 doped to have a first concentration (e.g., $1*10^8$/cm$^3$ to $5*10^{19}$/cm$^3$) and a second doped region 155 doped to have a second concentration ($\geq$ first concentration) (e.g., $10^{19}$/cm$^3$ or more). In another embodiment, the entire doped region 160 may be doped to have the same concentration. However, for convenience of description, the doped region 160 including the two regions 150 and 155 doped to have different concentrations is shown in the following description. The area and depth of the doping region 160 may vary.

The insulator layer 110 is disposed on the substrate 100 except for a portion of the doped region 160. For example, the insulator layer 110 does not exist on the top of a part or all of the first doped region 150 and is disposed on the substrate 100 to be exposed. In an embodiment, the insulator layer 110 may be formed of various oxides, such as silicon oxide, hafnium oxide, or aluminum oxide.

The graphene layer 120 made of graphene is stacked on the doped region 160 not covered by the insulator layer 110. For example, the graphene layer 120 may have a structure stacked on the insulator layer 110 and the doped region 160.

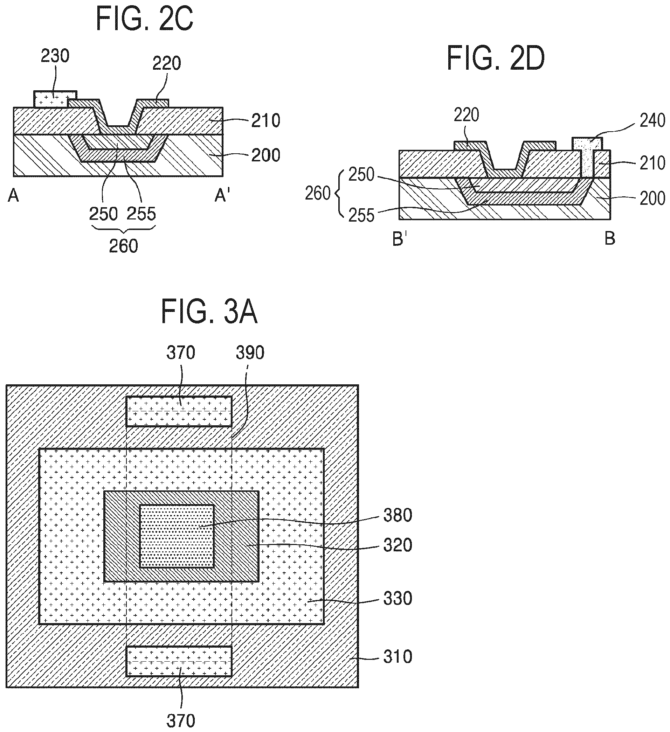

The first electrode 130 is connected to the graphene layer 120. The second electrode 140 is disposed under the substrate 100 and is connected to the doped region 160. In another embodiment, a via electrode 170 to be connected to the second electrode 140 on the lower surface of the substrate 100 may be further provided on the upper surface of the substrate 100. The via electrode 170 may pass through the insulator layer 110 and the substrate 100 to be connected to the second electrode 140 under the substrate 100. The connection structure of the first electrode 130 and the second electrode 140 of the present embodiment is only one example to facilitate understanding of the present disclosure, and the scope of the present disclosure is not limited to the present embodiment. Examples of various connection structures of the first electrode 130 and the second electrode 140 are shown in FIGS. 2 to 5 to follow.

A reaction layer 180 formed of a material for reacting with a specimen or a structure for sensing pressure may be further included on the surface of the graphene layer 120. The types of materials constituting the reaction layer may vary depending on the type of a specimen (e.g., light, biomaterial, gas, etc.). For example, the reaction layer 180 may be formed by applying biomaterials (DNA, antigens, antibodies, enzymes, etc.), quantum dots (e.g., lead sulfide quantum dots), polymer films, or the like to the graphene layer 120, or the reaction layer 180 formed of a structure for measuring pressure may be stacked on the graphene layer 120. In another embodiment, the reaction layer 180 may be formed of various materials or various layers. Depending on the type of material of the reaction layer 180 located on the surface of the graphene layer 120, the graphene-based sensor of the present embodiment may be used as various types of sensors, such as an optical sensor for detecting light, a biosensor for detecting biomaterials, an environmental sensor for detecting gas, temperature, humidity, or the like.

FIGS. 2A to 2D illustrate structures of a graphene-based sensor according to a second embodiment of the present disclosure. Specifically, FIG. 2A is a perspective view of the graphene-based sensor in the second embodiment, FIG. 2B is a plan view of the graphene-based sensor in the second embodiment, FIG. 2C is a cross-sectional view taken along line A-A' of the graphene-based sensor of the second embodiment in FIG. 2A, and FIG. 2D is a cross-sectional view taken along line B-B' of the graphene-based sensor of the second embodiment in FIG. 2A. The term "FIG. 2" may refer to any one of FIGS. 2A to 2D.

Referring to FIG. 2, the graphene-based sensor includes a substrate 200, an insulator layer 210, a graphene layer 220, a first electrode 230, a second electrode 240, and a doped region 260. The substrate 200, the insulator layer 210, the graphene layer 220, and the first electrode 230 have the same structures as those in FIG. 1. The depth and area of the doping region 260 may be the same as those of the first embodiment in FIG. 1 or may be partially modified.

The first electrode 230 is the same as that of the first embodiment in FIG. 1, but the second electrode 240 is different from that of the first embodiment in FIG. 1. The second electrode 240 is spaced apart from the first electrode 230 and passes through the insulator layer 210 and the substrate 200 to be connected to the doped region 260 (e.g., the first doped region 250 and/or the second doped region 255).

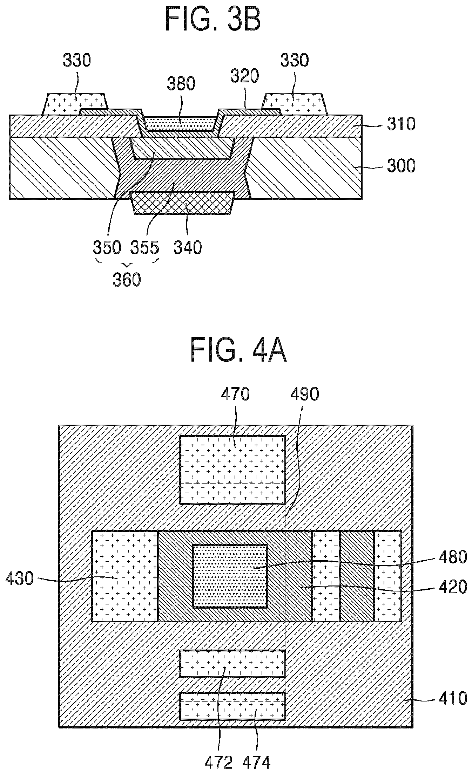

FIGS. 3A to 3B illustrate structures of a graphene-based sensor according to a third embodiment of the present disclosure. Specifically, FIG. 3A is a plan view of the graphene-based sensor in the third embodiment, and FIG. 3B is a cross-sectional view of the graphene-based sensor in the third embodiment. The term "FIG. 3" may refer to any one of FIGS. 3A to 3B.

Referring to FIG. 3, the graphene-based sensor includes a substrate 300, an insulator layer 310, a graphene layer 320, a first electrode 330, a second electrode 340, and a doped region 360. The configuration of the present embodiment is the same as that of the first embodiment in FIG. 1, except for the first electrode 330. The graphene-based sensor may further include a reaction layer 380.

While a structure in which the first electrode 130 is located on one side of the graphene layer 120 is provided in the first embodiment of FIG. 1, the first electrode 330 of the embodiment surrounds the periphery of the graphene layer 320 (e.g., a rectangular shape). In another embodiment, the first electrode 230 of the second embodiment may be deformed into a shape surrounding the graphene layer 220 as in the first electrode 330 of the present embodiment.

Although this embodiment shows two via electrodes 370 connected to the second electrode 340, the number of via electrodes 370 can be variously modified depending on the embodiment. In another embodiment, the via electrode 370 may be omitted.

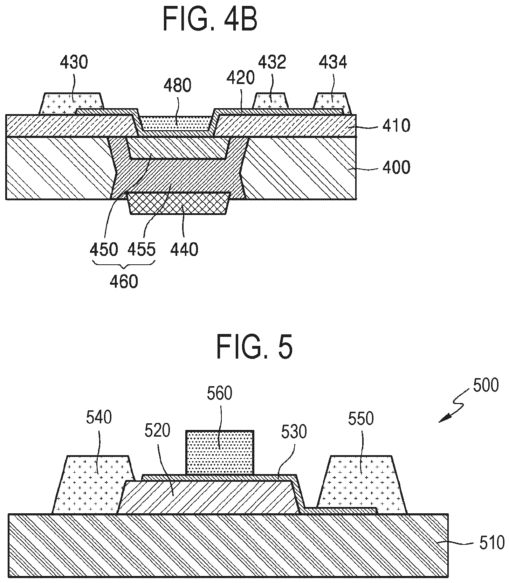

FIGS. 4A to 4B illustrate structures of a graphene-based sensor according to a fourth embodiment of the present disclosure. Specifically, FIG. 4A is a plan view of the graphene-based sensor of the fourth embodiment, and FIG. 4B is a cross-sectional view of the graphene-based sensor of the fourth embodiment. The term "FIG. 4" may refer to any one of FIGS. 4A to 4B.

Referring to FIG. 4, the graphene-based sensor includes a substrate 400, an insulator layer 410, a graphene layer 420, a first electrode 430, a second electrode 440, and a doped region 460. Compared to the first to third embodiments, the present embodiment further includes a plurality of electrodes 432, 434, 470, and 472. In the present embodiment, for convenience of explanation, the additional electrodes 432, 434, 470, and 472 are illustrated based on the structure of the first embodiment (i.e., the structure including a via electrode). However, the present embodiment may be implemented based on the structure of the second or third embodiment.

The third electrode 432 and the fourth electrode 434 are formed in contact with the graphene layer 420 to be spaced apart from the first electrode 430. The third electrode 432 and the fourth electrode 434 together with the first electrode 430 may be used to identify a bonding error of the first electrode 430 (e.g., a bonding error between the first electrode 430 and the graphene layer 420, etc.), or the third electrode 432 or the fourth electrode 434 may be used in case of a bonding error of the first electrode 430.

The fifth electrode 472 and the sixth electrode 474 pass through the insulator layer 410 and the substrate 400 and are connected to the second electrode 440 formed under the substrate 400. Accordingly, the fifth electrode 472 or the sixth electrode 474 may be used when a bonding error and the like occur in the via electrode 470. In addition, the via electrode 470 and the fifth electrode 472 (or the sixth electrode 474) may be used to identify whether the via electrode 470 is normally bonded to the second electrode 440.

According to the embodiment, the graphene-based sensor may include only a part of the third to sixth electrodes 432, 434, 470, and 472. For example, various modifications are possible such that the graphene-based sensor includes only the third electrode 432 or includes only the third electrode 432 and the fifth electrode 472.

An embodiment in which a substrate is implemented using a general semiconductor material has been described with reference to FIGS. 1 to 4. Hereinafter, an embodiment in which the substrate is implemented using a two-dimensional material will be described later with reference to FIG. 5.

FIG. 5 illustrates a structure of a graphene-based sensor according to a fifth embodiment of the present disclosure.

Referring to FIG. 5, a graphene-based sensor 500 includes a substrate 510, a two-dimensional semiconductor layer 520, a graphene layer 530, a first electrode 540, and a second electrode 550. According to an embodiment, the graphene-based sensor 500 may be implemented with a reaction layer 560 or without the reaction layer 560. Hereinafter, for convenience of description, it is assumed that the reaction layer 560 exists in the graphene-based sensor 500. In addition, a structure surrounding the periphery of the reaction layer 560 may be formed to prevent a specimen from flowing out of the reaction layer.

The two-dimensional semiconductor layer 520 is formed by laminating a two-dimensional material on the substrate 500. For example, the two-dimensional semiconductor layer 520 may be implemented using Si, Ge, WS2 or MoS. In addition to this, the two-dimensional semiconductor layer 520 may be implemented using various types of two-dimensional materials.

The graphene layer 530 is formed by stacking graphene over the substrate 510 and the two-dimensional semiconductor layer 520.

The first electrode 540 is stacked in contact with the two-dimensional semiconductor layer 520, and the second electrode 550 is stacked in contact with the graphene layer 530. That is, the first electrode 540 is connected to the two-dimensional semiconductor layer 520, and the second electrode 550 is connected to the graphene layer.

The reaction layer 560 is located on the surface of the region where the two-dimensional semiconductor layer 520 and the graphene layer 530 are stacked. The reaction layer 560 includes a material that induces electric charges in the graphene layer 530. The type of material constituting the reaction layer 160 may vary depending on the type of specimen (e.g., light, biomaterial, gas, etc.). For example, the reaction layer 560 may be formed by applying biomaterials (e.g., DNA, antigen, antibody, or enzyme), quantum dots (e.g., lead sulfide quantum dots), or a polymer film to the graphene layer 530, or the reaction layer 560 formed of a structure for measuring pressure may be stacked on the graphene layer 530. In another embodiment, the reaction layer 560 may include various materials or various layers. Depending on the type of material of the reaction layer 560 located on the surface of the graphene layer 530, the graphene-based sensor 500 of this embodiment may be used as various types of sensors, such as an optical sensor for detecting light, a biosensor for detecting biomaterials, an environmental sensor for detecting gas, temperature, humidity, or the like.

A sensor array may be made by arranging one or more graphene-based sensors of the first to fifth embodiments. When a plurality of graphene-based sensors are included in the sensor array, the sensor array may include graphene-based sensors having the same structure or a mixture of the graphene-based sensors of the first to fifth embodiments. However, for convenience of description, a sensor array formed by arranging a plurality of graphene-based sensors having the same structure will be described below.

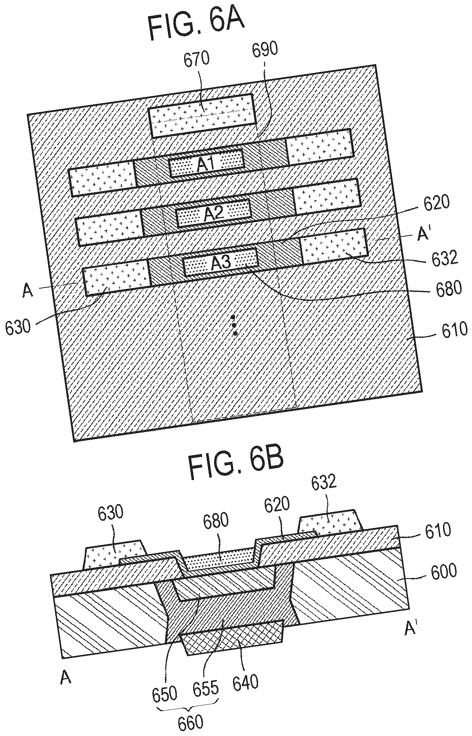

FIGS. 6A to 6B illustrate structures of a sensor array according to a first embodiment of the present disclosure. Specifically, FIG. 6A is a plan view of the sensor array of the first embodiment, and FIG. 6B is a cross-sectional view taken along line A-A' of the sensor array of the first embodiment in FIG. 6A. The term "FIG. 6" may refer to any one of FIGS. 6A to 6B.

Referring to FIG. 6, the sensor array has a structure in which a plurality of graphene-based sensors are arranged in one dimension. The graphene-based sensor constituting the sensor array is based on the structure of the third embodiment in FIG. 3. That is, the graphene-based sensor includes a substrate 600, an insulator layer 610, a graphene layer 620, a first electrode 630, a second electrode 640, and a doped region 660. The sensor array may further include an output terminal 632 configured to output a measurement value (e.g., an electrical signal such as current or voltage) of each graphene-based sensor. The output terminal 632 may correspond to the fourth electrode 434 described with reference to FIG. 4.

The second electrodes 640 of the plurality of graphene-based sensors constituting the sensor array are common electrodes connected to each other. In other words, a common electrode 590 vertically formed to cross the plurality of graphene-based sensors may be formed on the rear surface of the substrate 600. Although the via electrode 670 is shown in the present embodiment, the via electrode 670 may be omitted according to the embodiment.

The reaction layers 680 of the plurality of graphene-based sensors constituting the sensor array may all include the same material or may include different materials (A1, A2, and A3). For example, a sensor array configured to detect the wavelength or intensity of light may be implemented by the reaction layer 680 of each graphene-based sensor formed using different quantum dot materials. Alternatively, a sensor array configured to detect the type and/or amount of biomolecules may be implemented by the reaction layer 680 of each graphene-based sensor formed using biomolecules having different degrees of reaction to biomolecules (e.g., at least one of DNA, RNA, antigen, antibody, and enzyme). For example, the sensor array may identify corona virus and bird flu virus, or SARS-CoV-1 and SARS-CoV-2 among the corona viruses. Alternatively, a sensor array configured to detect the type and/or amount of a gas may be implemented by the reaction layer 680 of each graphene-based sensor formed using biomolecules having different degrees of reaction to a specific gas molecule. Alternatively, the reaction layer 680 of the sensor array may be formed by combining materials that react to quantum dots, biomolecules, gas molecules, and the like so that light, biomolecules, and gas molecules can be simultaneously detected through a single sensor array.

When the material or structure constituting the reaction layer 680 of each graphene-based sensor of the sensor array is different, the thickness of the insulator layer 610 may be at a predetermined height to prevent mixing the materials of the reaction layer 680 of each graphene-based sensor with each other.

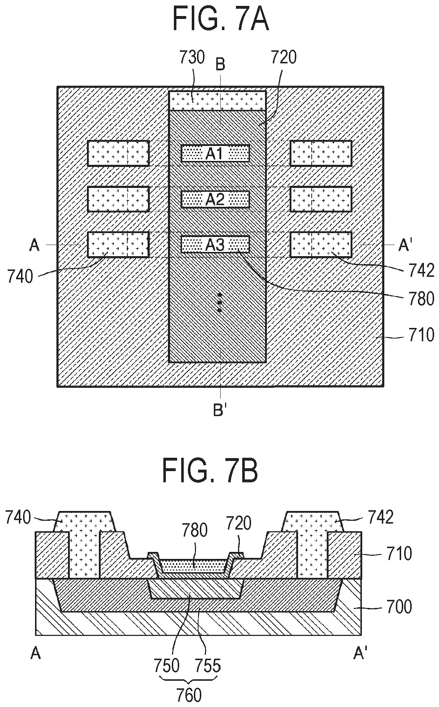

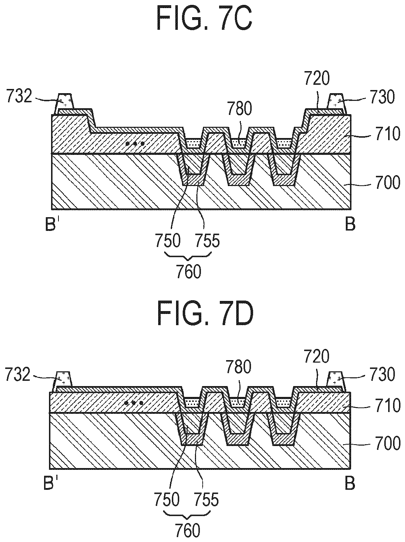

FIGS. 7A to 7D illustrate structures of a sensor array according to a second embodiment of the present disclosure. Specifically, FIG. 7A is a plan view of the sensor array of the second embodiment, FIG. 7B is a cross-sectional view taken along line A-A' of the sensor array in FIG. 7A of the second embodiment, FIG. 7C is an example of a cross-sectional view taken along line B-B' of the sensor array of the second embodiment in FIG. 7A, and FIG. 7D is another example of a cross-sectional view taken along line B-B' of the sensor array in FIG. 7A of the second embodiment. The term "FIG. 7" may refer to any one of FIGS. 7A to 7D.

Referring to FIG. 7, the sensor array includes a plurality of graphene-based sensors. Each graphene-based sensor constituting the sensor array includes a substrate 700, an insulator layer 710, a graphene layer 720, a first electrode 730, a second electrode 740, and a doped region 760. The graphene-based sensor of the present embodiment is obtained by partially modifying the structure in the second embodiment of FIG. 2.

The graphene layers 720 of the plurality of graphene-based sensors are connected to each other. In other words, the graphene layer 720 of the sensor array is stacked across the plurality of graphene-based sensors. Therefore, the first electrode 730 connected to the graphene layers 720 is a common electrode for the plurality of graphene-based sensors. A common electrode is the second electrode 640 in the case of the sensor array in FIG. 6 whereas a common electrode is the first electrode 730 in the present embodiment. The second electrode 740 is present in each graphene-based sensor. In addition, each graphene-based sensor may further include an output terminal 742 for outputting a measurement value.

As another embodiment, the insulator layer 710 may be formed in a stepwise manner (see FIGS. 7C and 7D). The present embodiment provides two examples together according to the height of the insulator layer 710. For example, the region of the insulator layer 710 where the first electrode 730 exists may be formed higher than the peripheral region thereof (see FIG. 7C). In this case, a specimen can be prevented from flowing out of the sensor array.

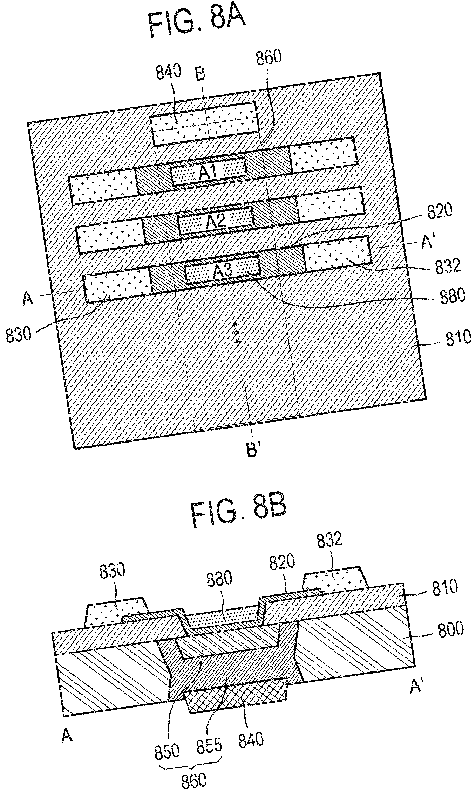

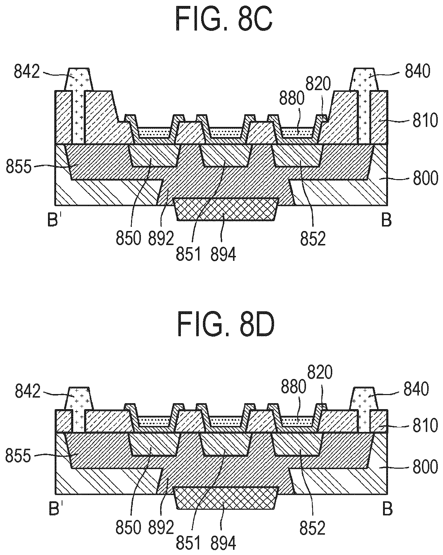

FIGS. 8A to 8D illustrate structures of a sensor array according to a third embodiment of the present disclosure. Specifically, FIG. 8A is a plan view of the sensor array of the third embodiment, FIG. 8B is a cross-sectional view taken along line A-A' of the sensor array in FIG. 8A of the third embodiment, FIG. 8C is an example of a cross-sectional view taken along line BB' of the sensor array in FIG. 8A of the third embodiment, and FIG. 8D is another example of a cross-sectional view taken along line BB' of the sensor array in FIG. 8A of the third embodiment. The term "FIG. 8" may refer to any one of FIGS. 8A to 8D.

Referring to FIG. 8, the sensor array includes a plurality of graphene-based sensors. Each graphene-based sensor constituting the sensor array includes a substrate 800, an insulator layer 810, a graphene layer 820, a first electrode 830, a second electrode 840, and a doped region 860.

The doped region 860 is formed lengthily in the vertical direction of the substrate 800 to cross the plurality of graphene-based sensors. For example, when the doped region 860 is formed of a plurality of regions having different concentrations, the doped region 860 includes a second doped region 855 crossing all the plurality of graphene-based sensors, and a plurality of first doped regions 850, 851, and 852 corresponding to the graphene layer 820 of each graphene-based sensor.

The second electrode 830 passes through the insulator layer 810 to be connected to the doped region 860 as in the second embodiment of FIG. 2. Although a structure including two second electrodes 840 and 842 is illustrated in the present embodiment, the number of second electrodes 840 and 842 may be variously modified according to embodiments. Since the second electrode 840 is connected to the doping region 860 crossing all the plurality of graphene-based sensors, the second electrode 840 becomes a common electrode for the plurality of graphene-based sensors. The first electrode 830 is present in each graphene-based sensor. An output terminal 832 for outputting a measurement value by each graphene-based sensor may be further included.

In another embodiment, the insulator layer 810 may be formed in a stepwise manner (see FIGS. 8C and 8D). The present embodiment provides two examples together according to the height of the insulator layer 810. For example, the region of the insulator layer 810 where the second electrode 840 exists may be formed higher than the peripheral region thereof as shown in the embodiment of FIG. 7C (see FIG. 8C). In another embodiment, separate additional electrodes 894 and 898 connected to the doped region 760 may be further provided on the lower surface of the substrate 800.

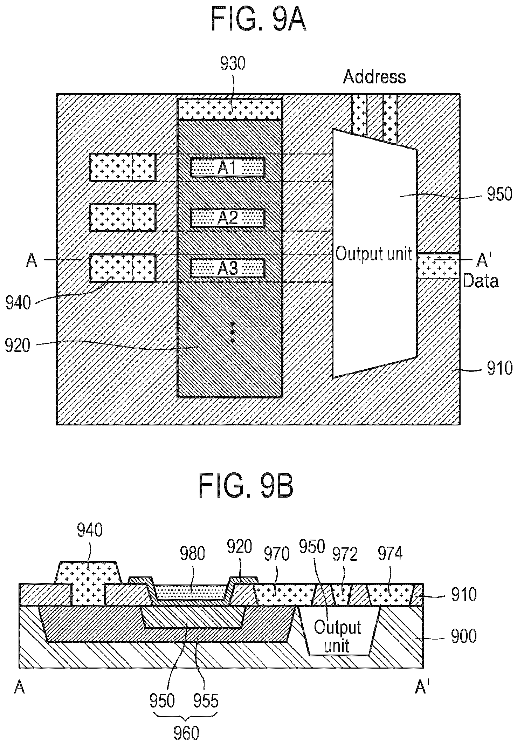

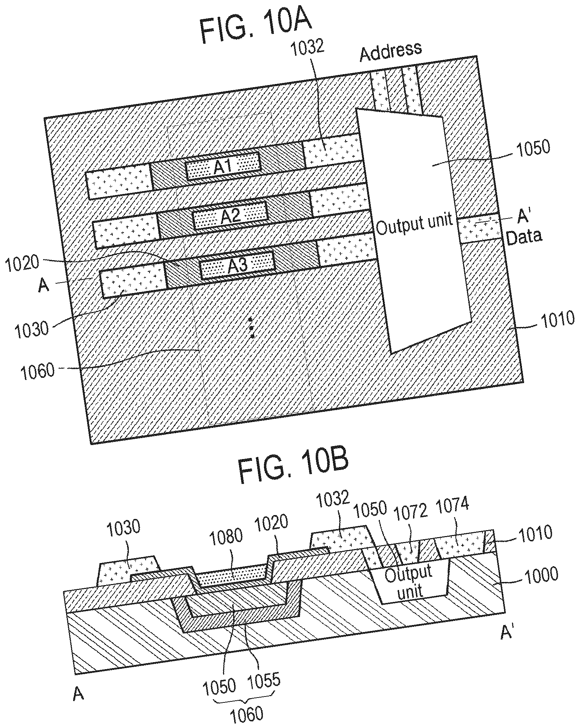

FIGS. 9A to 9B and FIGS. 10A to 10B illustrate structures of a sensor array according to fourth and fifth embodiments of the present disclosure. Specifically, FIG. 9A is a plan view of the sensor array of the fourth embodiment. FIG. 9B is a cross-sectional view taken along line A-A' of the sensor array in FIG. 9A of the fourth embodiment, FIG. 10A is a plan view of the sensor array of the fifth embodiment, and FIG. 10B is a cross-sectional view taken along line A-A' of the sensor array in FIG. 10A of the fifth embodiment. The term "FIG. 9" may refer to any one of FIGS. 9A to 9B, and the term "FIG. 10" may refer to any of FIGS. 10A to 10B.

Referring to FIGS. 9 and 10, the sensor array includes output units 950 and 1050 on substrates 900 and 1000, respectively. Each graphene-based sensor constituting the sensor array includes a substrate 900 or1000, an insulator layer 910 or 1010, a graphene layer 920 or 1020, a first electrode 930 or 1030, a second electrode 940 or 1040, and a doped region 960 or 1060. Reaction layers 980 and 1080 may be further provided on the surfaces of the graphene layers 920 and 1020, respectively. The structure of the sensor array of FIG. 9 is a structure partially modified from the structure of FIG. 7, and the structure of the sensor array of FIG. 10 is a structure partially modified from the structure of FIG. 8.

The output units 950 and 1050 may be implemented as semiconductor circuits on the substrates 900 and 1000, respectively.

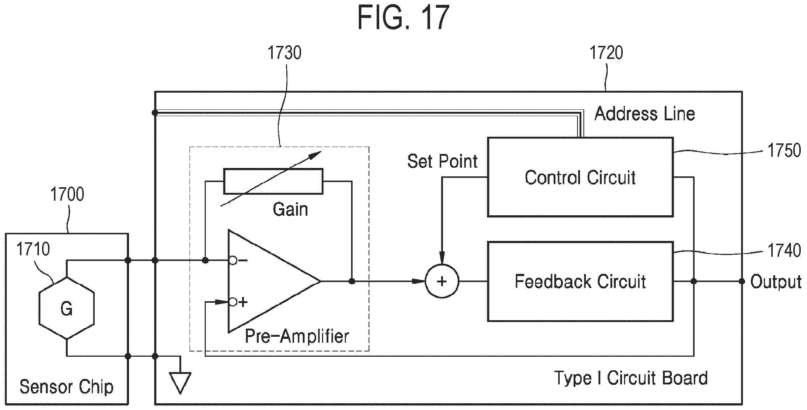

The output units 950 and 1050 respectively include terminals 972 and 1072 for receiving an address signal, output terminals 974 and 1074, and the like. The output units 950 and 1050 are connected to the output terminals 970 and 1032 of the plurality of graphene-based elements of the sensor array, respectively. When an address signal is received, the output unit 950 or 1050 selectively outputs a signal (e.g., a measurement value) received through an output terminal of a corresponding graphene-based element among a plurality of graphene-based elements. For example, the output units 950 and 1050 may be implemented as multiplexer circuits. Various embodiments of the output units 950 and 1050 are illustrated with reference to FIGS. 17 to 26.

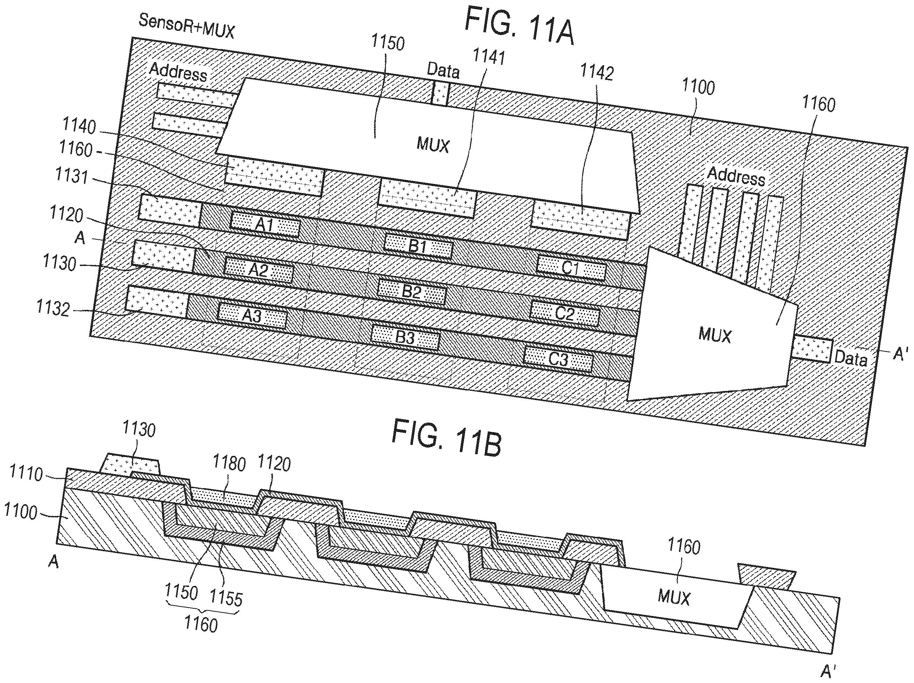

FIGS. 11A to 11B illustrate structures of a sensor array according to a sixth embodiment of the present disclosure. Specifically, FIG. 11A is a plan view of the sensor array of the sixth embodiment, and FIG. 11B is a cross-sectional view taken along line A-A' of the sensor array in FIG. 11A of the sixth embodiment. The term "FIG. 11" may refer to any one of FIGS. 11A to 11B.

Referring to FIG. 11, the sensor array has a structure in which graphene-based sensors are arranged in the form of n*m (n, m are natural numbers greater than or equal to 2). Each graphene-based sensor includes a substrate 1100, an insulator layer 1110, a graphene layer 1120, a first electrode 1130, a second electrode 1140, and a doped region 1160. In addition to this, each graphene-based sensor of the sensor array may be implemented in the structure of various embodiments shown in FIGS. 1 to 5.

The graphene layer 1120 is stacked in units of rows over a plurality of graphene-based sensors. For example, the graphene layers of three graphene-based sensors located in the first row are connected to each other. Therefore, the common first electrode 1130 exists in each row.

The doping region 1160 exists in units of columns over a plurality of graphene-based sensors. For example, doped regions of three graphene-based sensors located in the first row are connected to each other, doped regions of three graphene-based sensors located in the second row are connected to each other, and doped regions of three graphene-based sensors located in the third row are connected to each other. Therefore, the common second electrode 1140 exists in units of columns. For example, as shown in FIG. 8, second electrodes 1140 passing through the insulator layer 1110 to be connected to the doping region 1160 exist in each row.

A measurement value by a desired graphene-based sensor among the plurality of graphene-based sensors may be output through the plurality of first electrodes 1130, 1131, and 1132 and the plurality of second electrodes 1140, 1141, and 1142. For example, the B2 sensor may be operated by applying a signal to the first electrode in the first row and the second electrode in the second column.

A first multiplexer 1150 and a second multiplexer 1160 may be included to selectively control the operation of each graphene-based sensor and selectively output a measurement value by each graphene-based sensor. In an embodiment, the first multiplexer 1150 and the second multiplexer 1160 may be implemented as semiconductor circuits on the substrate 1100. The first multiplexer 1150 may be connected to the plurality of second electrodes 1140, 1141, and 1142, and the second multiplexer 1150 may be connected to output terminals (not shown) of the plurality of graphene-based sensors. For example, the first multiplexer 1150 receives and outputs, when receiving an address signal, a signal of a column corresponding to the address signal, among the plurality of second electrodes 1140, 1141, and 1142, and the second multiplexer 1160 receives and outputs, when receiving an address signal, a signal of a row corresponding thereto.

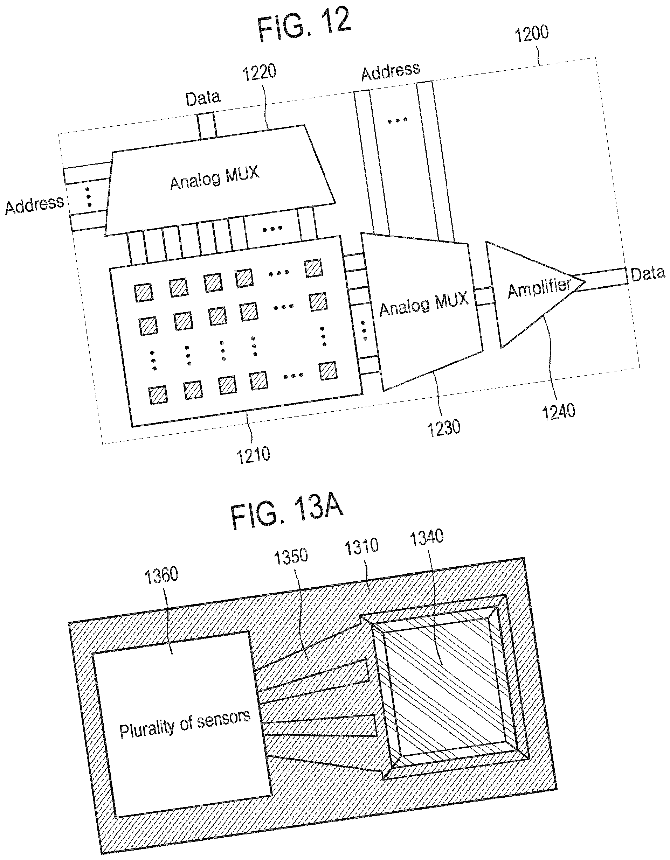

FIG. 12 illustrates a structure of a sensor array according to a seventh embodiment of the present disclosure.

Referring to FIG. 12, structures of a plurality of graphene-based sensors 1210 and two multiplexers 1220 and 1240 of the sensor array are the same as those of FIG. 11. The present embodiment further includes an amplifier 1240. The amplifier 1240 is connected to the second multiplexer 1230 to amplify an output signal of the second multiplexer 1230. The sensor array including the amplifier 1240 of the present embodiment may be implemented in the form of a chip.

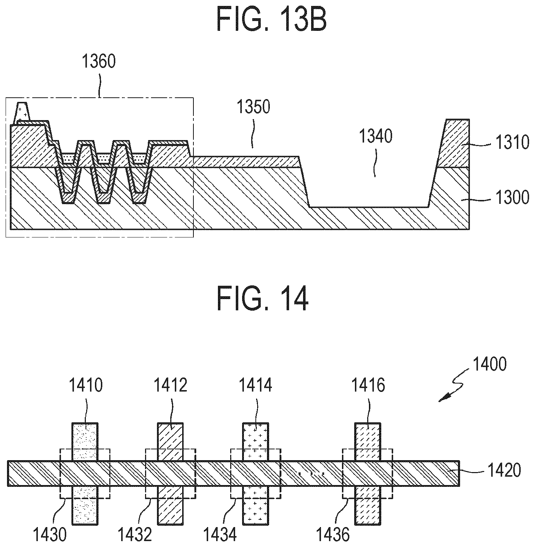

FIGS. 13A to 13B illustrate structures of a sensor array according to an eighth embodiment of the present disclosure. Specifically, FIG. 13A is a plan view of the sensor array of the eighth embodiment, and FIG. 13B is a cross-sectional view of the sensor array of the eighth embodiment. The term "FIG. 13" may refer to any one of FIGS. 13A to 13B.

Referring to FIG. 13, the sensor array includes a plurality of graphene-based sensors 1360. The structure of the sensor array may be any one of the structures of FIGS. 6 to 12. In addition, the structure of the sensor array may be any one of the structures of FIGS. 14 to 15 to be described later. The sensor array 1360 also includes a storage unit 1340 and a channel unit 1350.

The storage unit 1340 is formed by etching the substrate 1300 to a predetermined depth and width. The plurality of graphene-based sensors are connected to the storage unit 1340 through the channel unit 1350. The channel unit 1350 may be formed by etching a portion of the insulator layer 1310 between the plurality of graphene-based sensors 1360 and the storage unit 1340 to a predetermined depth and width.

The depth and width of the channel unit 1350 may be formed smaller than the depth and width of the storage unit 1340 so that, among specimens stored in the storage unit 1340, only materials having a predetermined size or less are transferred to the plurality of graphene-based sensors 1360 through the channel unit 1350. For example, when the specimen is blood, the channel unit 1350 may be formed to have a width less than a predetermined width (e.g., less than 6 $\mu$m) so that only materials other than red blood cells and white blood cells are transferred to the graphene-based sensor 1360.

Although a structure further including the storage unit 1340 and the channel unit 1350 in the sensor array structure is illustrated in the present embodiment, the configuration of the storage unit 1340 and the channel unit 1350 may also be applied to the graphene-based single sensor described with reference to FIGS. 1 to 5.

FIG. 14 illustrates a structure of a sensor array according to a ninth embodiment of the present disclosure.

Referring to FIG. 14, the sensor array 1400 includes a plurality of sensing regions 1430, 1432, 1434, and 1436 in which two-dimensional semiconductor layers 1410, 1412, 1414, and 1416 and a graphene layer 1420 are stacked. The plurality of sensing regions 1430, 1432, 1434, and 1436 each serves as the graphene-based sensor described with reference to FIG. 5.

The plurality of two-dimensional semiconductor layers 1410, 1412, 1414, and 1416 are disposed on the substrate to be spaced apart from each other, and the graphene layer 1420 is stacked on the plurality of two-dimensional semiconductor layers 1410, 1412, 1414, and 1416. For example, the plurality of two-dimensional semiconductor layers 1410, 1412, 1414, and 1416 may be arranged to be spaced apart from each other at a predetermined interval in a first direction (e.g., a vertical direction), and the graphene layer 1420 may be stacked across the plurality of two-dimensional semiconductor layers 1410, 1412, 1414, and 1416 in a second direction (e.g., a horizontal direction) perpendicular to the first direction. The graphene layer 1420 is connected in common to the plurality of sensing regions 1430, 1432, 1434, and 1436.

In an embodiment, the plurality of two-dimensional semiconductor layers 1410, 1412, 1414, and 1416 may be implemented using the same two-dimensional material or different two-dimensional materials. Alternatively, only some of the two-dimensional semiconductor layers (at least two of 1410, 1412, 1414, and 1416) may be implemented using different two-dimensional materials.

In another embodiment, the sensing regions 1430, 1432, 1434, and 1436 in which the plurality of two-dimensional semiconductor layers 1410, 1412, 1414, and 1416 and the graphene layer 1420 are stacked may have different sizes. For example, at least two of two-dimensional semiconductor layers 1410, 1412, 1414, and 1416 may have different widths. Alternatively, the widths of the graphene layer 1420 corresponding to the sensing regions 1430, 1432, 1434, and 1436 may be implemented to be different.

Although only the two-dimensional semiconductor layers 1410, 1412, 1414, and 1416 and the graphene layer 1420 are illustrated in the present embodiment for convenience of description, the structure of each sensing region 1430, 1432, 1434, or 1426 may include the same structure as shown in FIG. 5. For example, a plurality of first electrodes (not shown) are connected to the plurality of two-dimensional semiconductor layers 1410, 1412, 1414, and 1416, and one second electrode (not shown) may be connected to the graphene layer 1420.

A reaction layer (not shown) may be present in each of the sensing regions 1430, 1432, 1434, and 1436 in which the two-dimensional semiconductor layers 1410, 1412, 1414, and 1416 and the graphene layer 1420 are stacked. Materials constituting the reaction layer of each sensing region may be the same as or different from each other.

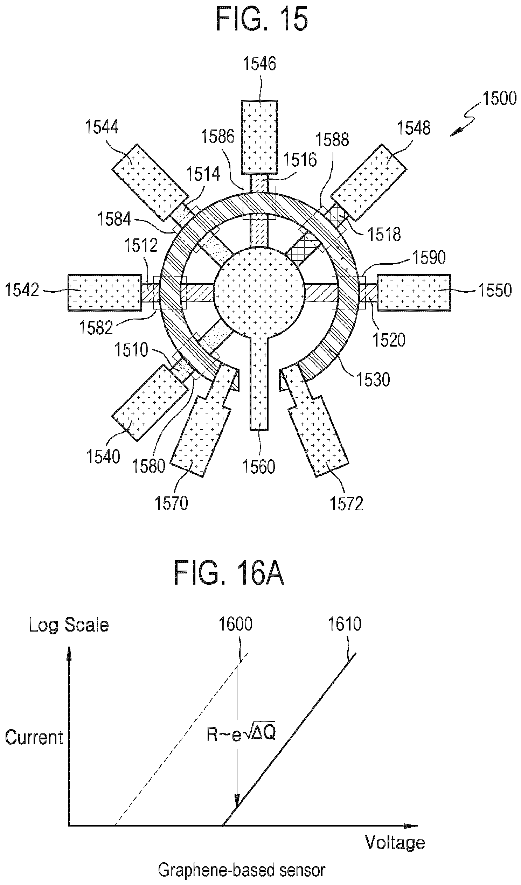

FIG. 15 illustrates a structure of a sensor array according to a tenth embodiment of the present disclosure.

Referring to FIG. 15, the sensor array 1500 includes a plurality of sensing regions 1580, 1582, 1584, 1586, 1588, and 1590 in which two-dimensional semiconductor layers 1510, 1512, 1514, 1516, 1518, and 1520 and a graphene layer 1530 are stacked. The plurality of two-dimensional semiconductor layers 1510, 1512, 1514, 1516, 1518, and 1520 may be radially disposed on the substrate to be spaced apart from each other, and the graphene layer 1530 may be stacked in a circular band shape over the plurality of two-dimensional semiconductor layers 1510, 1512, 1514, 1516, 1518, and 1520.

A plurality of first electrodes 1540, 1542, 1544, 1546, 1548, and 1550 are connected to the plurality of two-dimensional semiconductor layers 1510, 1512, 1514, 1516, 1518, and 1520, respectively, and the second electrode 1570 is connected to the graphene layer 1530.

The sensor array 1500 may further include a third electrode 1560 connected in common to the plurality of two-dimensional semiconductor layers 1510, 1512, 1514, 1516, 1518, and 1520. Since the plurality of two-dimensional semiconductor layers 1510, 1512, 1514, 1516, 1518, and 1520 are radially arranged, a third electrode 1560 may be disposed inside the radial arrangement thereof to be connected in common to the plurality of two-dimensional semiconductor layers 1510, 1512, 1514, 1516, 1518, and 1520. States (e.g., failure, etc.) of the respective two-dimensional semiconductor layers 1510, 1512, 1514, 1516, 1518, and 1520 may be checked through the plurality of first electrodes 1540, 1542, 1544, 1546, 1548, and 1550 and the third electrode 1560.

The sensor array 1500 may further include a fourth electrode 1572 connected to the graphene layer 1530. For example, the graphene layer 1530 may have a partially open circular band shape, and the second electrode 1570 and the fourth electrode 1572 may be connected to both ends of the graphene layer 1530, respectively. A state (e.g., a failure state, etc.) of the graphene layer 1530 may be checked through the second electrode 1570 and the fourth electrode 1572.

Sensed values of the sensing regions 1580, 1582, 1584, 1586, 1588, and 1590 may be measured through the second electrode 1570 and the plurality of first electrodes 1540, 1542, 1544, 1546, 1548, and 1550 connected to the plurality of two-dimensional semiconductor layers 1510, 1512, 1514, 1516, 1518, and 1520, respectively.

The frequency or intensity of light, biomolecules, gas molecules, or pressure can be detected using the sensor array described with reference to FIGS. 6 to 15. For example, the graphene layer of each graphene-based sensor or the reaction layer located on the surface of the sensing region may be formed of antibodies of various viruses or bacteria to detect the type of antigen possessed by a specimen. Alternatively, the reaction layer may be formed of antigens including specific proteins of various viruses or bacteria to detect the type of antibody possessed by a specimen. Alternatively, the reaction layer may be formed of antibodies reacting to various pathogens to different degrees to detect the types of pathogens. Alternatively, the reaction layer may be formed of various enzymes to detect various types of materials reacting to the enzymes.

In another embodiment, the reaction layer of the graphene-based sensor constituting a sensor array may be formed of molecules having different degrees of reaction to specific gas molecules to detect the type and amount of the gas molecules. In another embodiment, the reaction layer may be formed of a structure that responds to pressure to detect the intensity of the pressure.

In another embodiment, a reaction layer of a plurality of graphene-based sensors constituting a sensor array may be formed of nucleic acids to detect a sequence of the nucleic acids. For example, a material of the reaction layer may be formed of a single-stranded nucleic acid of about 20 base-pairs to implement a sensor array capable of detecting even a base-pair. For example, the reaction layer of the first graphene-based sensor may be formed of a nucleic acid having a complementary sequence with respect to a first nucleic acid having a specific sequence, and the reaction layer of the second graphene-based sensor may be formed of a nucleic acid having a complementary sequence with respect to a second nucleic acid in which a part of the first nucleic acid is mutated. If a specimen in which the concentrations of the first nucleic acid and the second nucleic acid are C1 and C2, respectively, is input to the sensor array, measurement values (S1, S2) by the sensor array are displayed as follows,

【Equation 1】

$$\begin{pmatrix} S_1 \\ S_2 \end{pmatrix} = \begin{pmatrix} M_{11} & M_{12} \\ M_{21} & M_{22} \end{pmatrix} \begin{pmatrix} C_1 \\ C_2 \end{pmatrix}$$

wherein $M_{nm}$ indicates the magnitude of a signal indicated by a graphene-based sensor when a nucleic acid having a sequence of n is combined with a complementary sequence of a sequence of m. $M_{nm}$ may be identified and defined experimentally in advance. From the above Equation, the concentrations of the first nucleic acid and the second nucleic acid in the specimen may be obtained as follows.

【Equation 2】

$$\begin{pmatrix} C_1 \\ C_2 \end{pmatrix} = \begin{pmatrix} M_{11} & M_{12} \\ M_{21} & M_{22} \end{pmatrix}^{-1} \begin{pmatrix} S_1 \\ S_2 \end{pmatrix}$$

That is, the concentrations of the first nucleic acid and the second nucleic acid of the specimen can be identified by the identified measurement values S1 and S2 by the sensor array. Although the above example is described using two types of nucleic acids, three or more types of nucleic acids can be detected by the same method.

In another embodiment, concentrations of various materials (e.g., calcium, sodium, blood sugar, etc.) in blood may be measured. The reaction layer of the graphene-based sensor constituting the sensor array may be formed of various enzymes or channels to detect concentrations of ions and blood sugar in the blood. For example, the reaction layer of the first graphene-based sensor may be formed of glucose oxidase and the reaction layer of the second graphene-based sensor may be formed of a potassium channel to measure the concentrations of glucose and potassium in the blood. In addition, the sensor array may be configured to include various enzyme reactions and various channels to measure the concentration of various materials in the specimen at the same time.

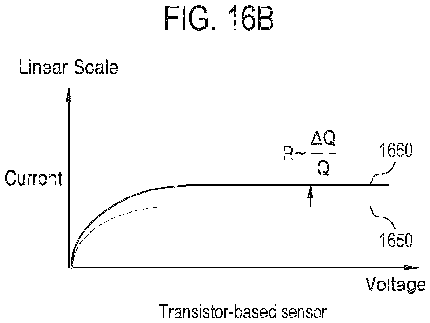

FIGS. 16A and 16B illustrate examples of a change in a current of a graphene-based sensor according to the present disclosure. Specifically, FIG. 16A illustrates the change in a current of a graphene-based sensor, and FIG. 16B illustrates the change in a current of a transistor-based sensor. The term "FIG. 16" may refer to any one of FIGS. 16A to 16B.

Referring to FIG. 16, the output currents 1600 and 1610 of the graphene-based sensor change according to the reaction degree of the reaction layer. In addition, the output currents 1610 and 1610 of the graphene-based sensor may vary depending on the type of material constituting the reaction layer. However, the graphene-based sensor can accurately measure minute changes in electrical signals since the sensitivity of the output currents 1600 and 1610 of the graphene-based sensor of the present embodiment is greater than the output currents 1650 and 1660 of the transistor-based sensor of the related art. The wavelength or intensity of light, the type or amount of biomolecules, the type or amount of gas molecules, or the intensity of pressure may be detected using changes in the output currents 1600 and 1610.

The output currents 1600 and 1610 of the graphene-based sensor change in a logarithmic scale, and thus the measurement range thereof is very wide, causing difficulties in accurately measuring the same. Therefore, FIGS. 17 to 26 present methods and devices for converting the output currents 1600 and 1610 of the graphene-based sensor into a voltage within a predetermined range (e.g., 0 to 10 V, etc.) and measuring the voltage.

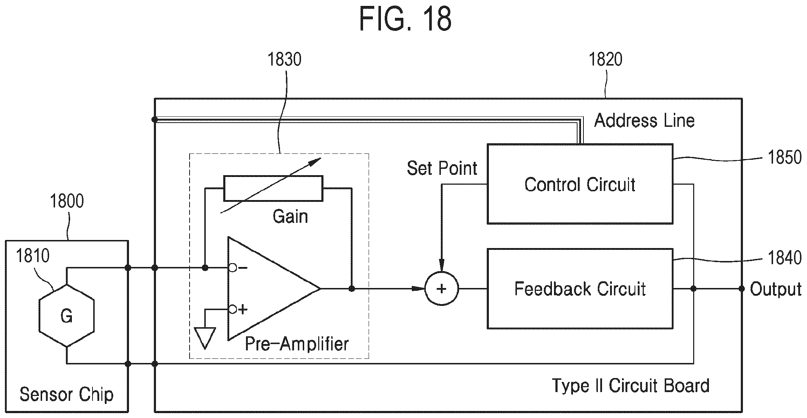

FIGS. 17 and 18 illustrate various examples of a measurement device using a graphene-based sensor according to the present disclosure.

Referring to FIGS. 17 and 18, the measurement device includes a graphene-based sensor 1710 or 1810 and an output unit 1720 or 1820. The graphene-based sensor 1710 or 1810 may be implemented in the form of a chip 1700 or 1800. The output unit 1720 or 1820 includes a preamplification unit 1730 or 1830 and a feedback unit 1740 or 1840. According to embodiments, the measurement device may further include a controller 1750 or 1850.

The preamplification unit 1730 or 1830 converts the output current of the graphene-based sensor 1710 or 1810 into a voltage. In other words, the preamplification unit 1730 or 1830 outputs a voltage within a predetermined range when receiving a current as an input. In an embodiment, the preamplification unit 1730 or 1830 may include an amplifier and a variable resistance, and perform adjustment through adjustment of the variable resistance such that the output voltage of the amplifier is within a predetermined range (e.g., 0 to 10 V). The structure of the preamplification unit 1730 or 1830 of the present embodiment is only an example for understanding, and various circuit structures of the related art that convert a current input into a voltage and output the voltage may be used in the preamplification unit 1730 or 1830 of the present embodiment.

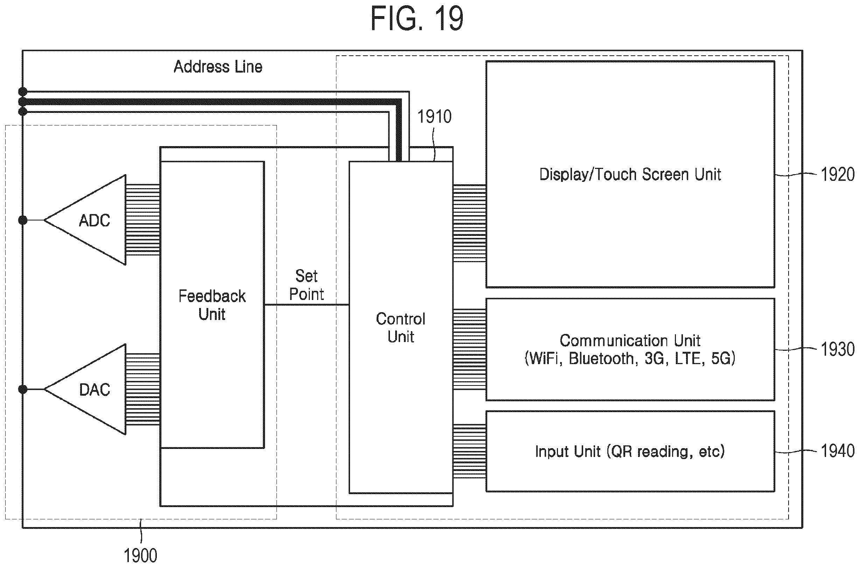

The feedback unit 1740 or 1840 performs feedback-control on the output voltages of the preamplification unit 1730 or 1830 according to a set point of the controller 1750 or 1850 and output the same. As shown in FIG. 16, the graphene-based sensor 1710 or 1810 shows different graphs of output currents 1600 and 1610 according to the reaction materials in the reaction layer, and accordingly, the feedback unit 1740 or 1840 adjusts the output voltage of the preamplification unit 1730 or 1830 according to the set point. For example, when the range of output voltage of the preamplification unit 1730 or 1830 is 0 to 10 V and the set point is 1 V, the feedback unit 1740 or 1840 adjusts the output voltage of the preamplification unit 1730 or 1830 to a point between 0-1 V and outputs the same. The feedback unit 1740 or 1840 configured to adjust the range of the output voltage according to a set point may be implemented as an analog circuit or implemented as a digital signal processor (DSP). An example of a feedback unit implemented as the DSP is illustrated in FIG. 19.

Connections between the preamplification unit 1730 or 1830 and the graphene-based sensor 1710 or 1810 may be implemented in various forms. For example, referring to FIG. 17, the (-) terminal of the amplifier may be connected to the output terminal of the graphene-based sensor 1710, and the (+) terminal of the amplifier may be connected to the output of the feedback unit 1740. Referring to FIG. 18, the (-) terminal of the amplifier may be connected to the output terminal of the graphene-based sensor 1810, and the (+) terminal of the amplifier may be connected to the ground. In this case, the remaining electrodes of the graphene-based sensor 1810 may be connected to the output of the feedback unit 1840.

FIG. 19 illustrates an example of a detailed configuration of a feedback unit and a controller of a measurement device according to the present disclosure.

Referring to FIG. 19, the feedback unit 1900 is implemented as a DSP. When the feedback unit 1900 receives a voltage in a predetermined range (e.g., the first range), the feedback unit 1900 performs feedback control on the value of the output voltage of the preamplification unit 1730 or 1830 described above and adjusts the value to a voltage in a predetermined range (e.g., the second range < the first range) to output the same. Various circuit structures of the related art, configured to perform feedback control on the output voltage of the preamplification unit 1730 or 1830 to output the voltage in a predetermined range may be applied to the feedback unit 1900 of the present embodiment, and the feedback unit 1900 is not limited to the structure of the present embodiment. The measurement device may further include a display unit 1920, a communication unit 1930, an input unit 1940, and the like along with the control unit 1910.

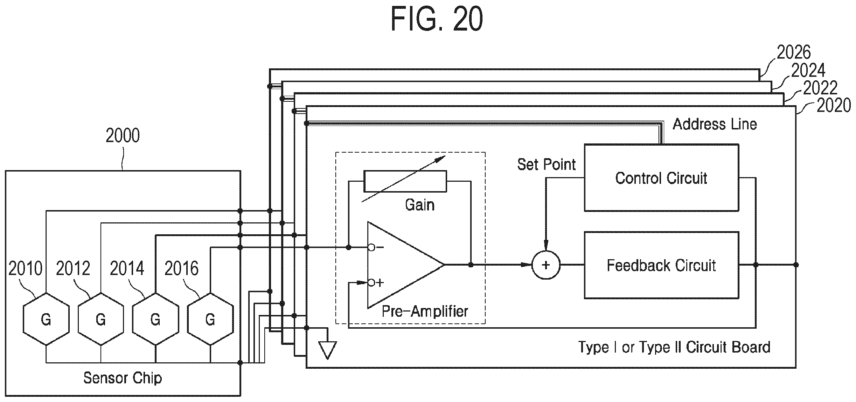

FIGS. 20 to 26 illustrate various examples of a measurement device using a sensor array according to the present disclosure.

Referring to FIG. 20, the measurement device includes a plurality of output units 2020, 2022, 2024, and 2026 that output measurement values of the plurality of graphene-based sensors 2010, 2012, 2014, and 2016 included in the sensor array 2000. Each of the output units 2020, 2022, 2024, and 2026 may be implemented in the structure of FIG. 17 or 18. For example, when the sensor array 2000 includes four graphene-based sensors 2010, 2012, 2014, and 2016, the four output units 2020, 2022, 2024, and 2026 are connected to the graphene-based sensors 2010, 2012, 2014, and 2016, respectively. Since output units are required as many as the number of graphene-based sensors included in the sensor array 2000, the size of the measurement device increases in proportion to the number of the graphene-based sensors.

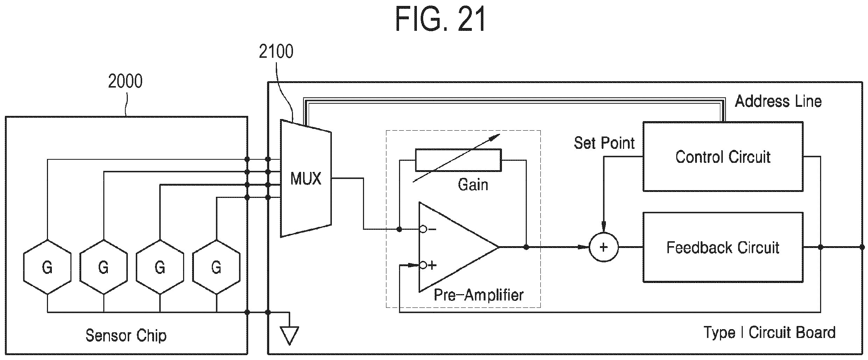

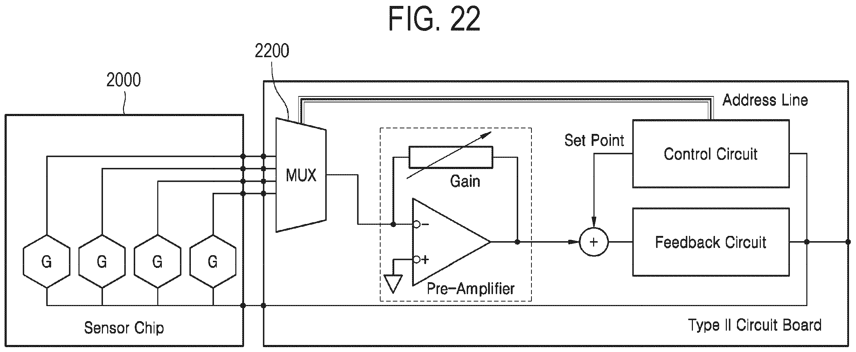

Referring to FIGS. 21 and 22, the measurement device includes an output unit to which a multiplexer 2100 or 2200 is added. In the embodiment of FIG. 20, the sensor array 2000 needs to include output units as many as the number of graphene-based sensors included therein, but only needs to include one output unit in the present embodiment. The multiplexer 2100 or 2200 selectively receives output currents from the plurality of graphene-based sensors of the sensor array 2000 and outputs voltages. FIG. 21 is a structure obtained by connecting the multiplexer 2100 to an element of the output unit 1720 in FIG. 17, and FIG. 22 is a structure obtained by connecting the multiplexer 2200 to an element of the output unit 1820 in FIG. 18.

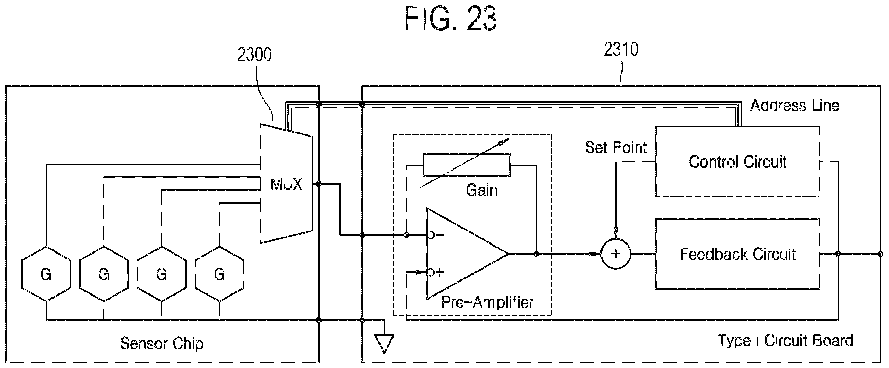

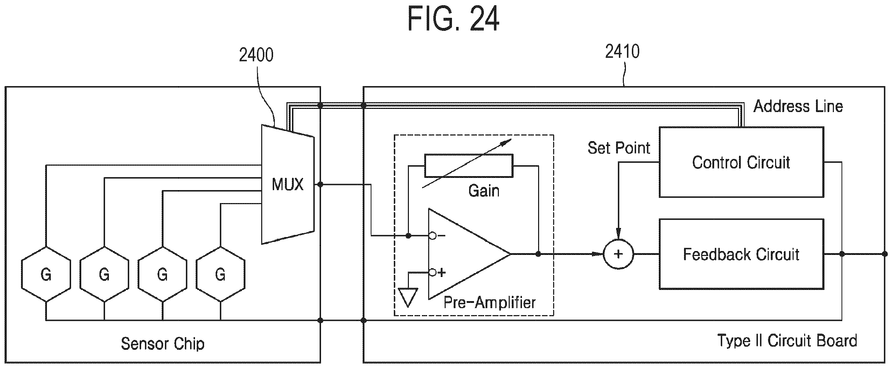

Referring to FIGS. 23 and 24, a sensor array and a multiplexer 2300 or 2400 are implemented as a single chip. In this case, the sensor array selectively outputs measurement values of the plurality of graphene-based sensors through the multiplexer 2300 or 2400, and thus, the output unit 2310 or 2410 may be configured as a single element. The output unit 2310 of FIG. 23 is identical to the output unit 1720 of FIG. 17, and the output unit 2110 of FIG. 24 is identical to the output unit 1830 of FIG. 18.

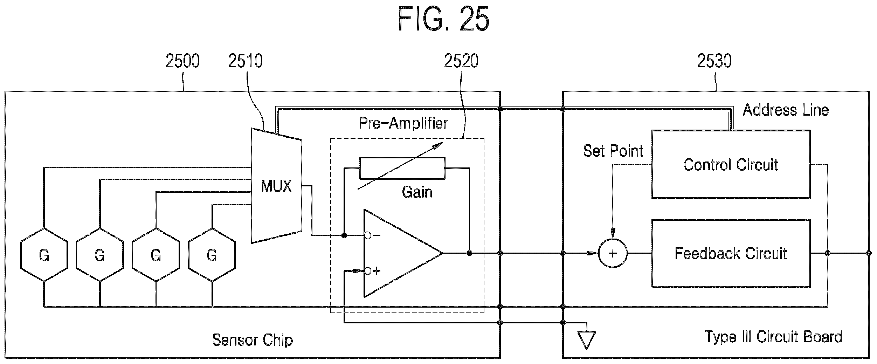

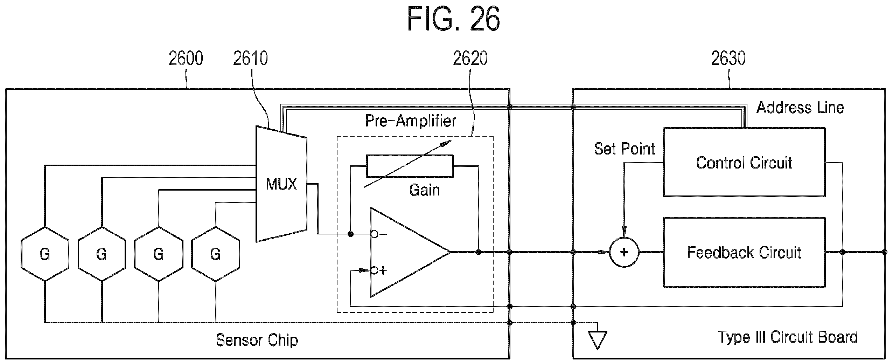

Referring to FIGS. 25 and 26, a sensor array, a multiplexer 2510 or 2610, and a preamplification unit 2520 or 2620 are implemented as a single chip 2500 or 2600. The output unit 2530 or 2630 includes a feedback unit and a control unit. The output unit 2530 in FIG. 25 is implemented based on the structure of the output unit 1820 in FIG. 18, and the output unit 2630 in FIG. 26 is implemented based on the structure of the output unit 1720 of FIG. 17.

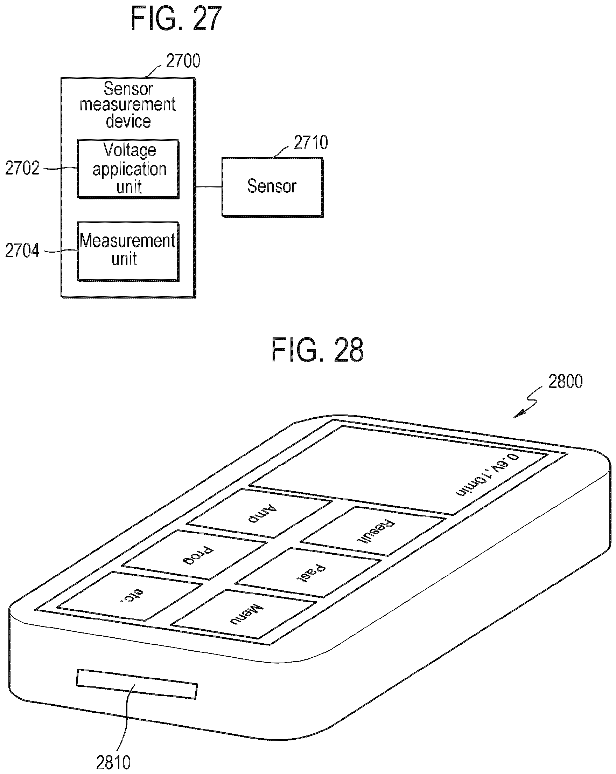

FIG. 27 illustrates a block diagram of a measurement device according to the present disclosure.

Hereinafter, a sensor measurement device 2700 will be described as an example of the measurement device. The sensor measurement device 2700 may be implemented as a computing device that performs a computing function.

Referring to FIG. 27, the sensor measurement device 2700 includes a voltage application unit 2702 and a measurement unit 2704. The sensor measurement device 2700 may be implemented in various forms, and FIGS. 17 to 26 may be referred to as examples. A sensor 2710 may output different currents or resistances according to the type of specimen. Various types of sensors 2710 may be used in the present embodiment. In another embodiment, a graphene-based sensor may be used to increase the sensitivity of the sensor. FIGS. 1 to 15 and 17 to 26 may be referred to as examples of graphene-based sensors.

A voltage application unit 2702 applies at least one voltage to the sensor 2710 within a predefined voltage range. For example, the voltage application unit 2702 inputs a voltage between 0 and 2 V to the sensor 2710 at regular intervals (e.g., 0.1 V intervals). According to embodiments, the voltage range and the voltage application interval may be variously modified.

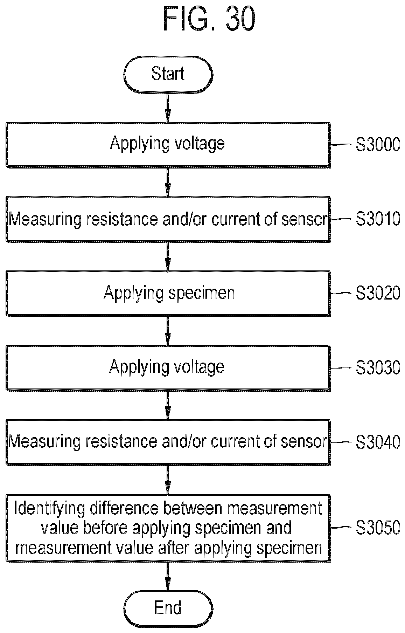

The measurement unit 2704 measures resistance or current of the sensor 2710 according to the application of voltage. The measurement unit 2704 detects the resistance or current of the sensor for each voltage. For example, the measurement unit 2704 detects the measurement value of the resistance or current of the sensor 2710 according to the application of voltage before a specimen is applied, and detects the measurement value of the resistance or current of the sensor 2710 according to the application of voltage after the specimen is applied. A measurement method using the sensor measurement device 2700 will be described later with reference to FIGS. 30 to 33.

The measurement unit 2704 may display a measurement result through a screen interface, output whether a specimen is recognized through a sound, or transmit the measurement result to an external device through a wired or wireless communication network. The type of information displayed or transmitted by the measurement unit 2704 may be variously modified according to embodiments.

FIGS. 28 to 29 illustrate implementation examples of a measurement device according to the present disclosure.

Referring to FIG. 28, a measurement device 2800 may be implemented in a small portable size. An insertion hole 2810 into which a diagnostic strip is insertable is provided in one side of the measurement device 2800. The diagnostic strip 2810 has a long and thin rod shape, and the diagnostic strip 2810 having a specimen smeared thereon may be inserted into the insertion hole 2810 of the measurement device 2800.

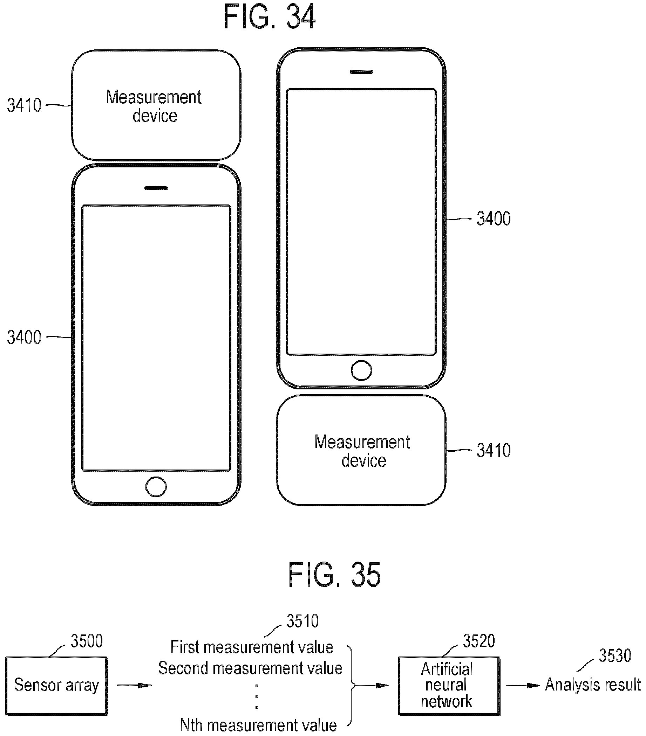

As an embodiment, the measurement device 2800 may transmit a measurement value of a graphene-based sensor to an external device such as a smartphone. In this regard, an example of using the measurement device will be described later with reference to FIG. 34. In another embodiment, the measurement device 2800 may further include an internal circuit capable of analyzing the measurement value by the graphene-based sensor. This will be described later with reference to FIGS. 35 to 36. In addition, the measurement device 2800 may further include a display capable of displaying analysis results or a communication unit capable of transmitting analysis results to the outside through a wired or wireless network.

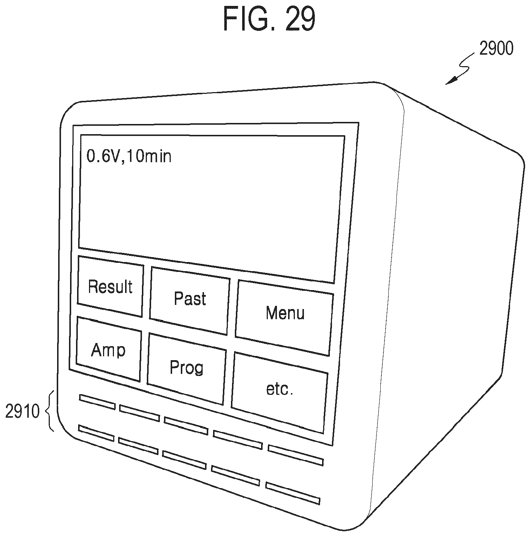

Referring to FIG. 29, a measurement device 2900 includes a plurality of insertion holes 2910 into which a plurality of diagnostic strips can be inserted, and a plurality of graphene-based sensors capable of simultaneously analyzing a plurality of diagnostic strips inserted through the insertion holes 2910. The plurality of graphene-based sensors included in the measurement device 2900 may exist separately in each insertion hole 2910 or may exist as the sensor array structure described above.

The measurement device 2900 may include an internal circuit capable of analyzing output values of a plurality of graphene-based sensors. This will be described later with reference to FIGS. 35 to 36. The measurement device 2900 may further include a display unit configured to display analysis results, and a communication unit capable of transmitting analysis results to an external device.

In another embodiment, quantitative analysis of a specimen may be performed using the measurement device 2800 or 2900 of FIG. 28 or 29. As shown in FIG. 28, when a single insertion hole 1810 is included in the measurement device 2800, a plurality of diagnostic strips containing a plurality of standard samples of different concentrations and a diagnostic strip of a specimen are sequentially inserted into the insertion hole 2810 of the measurement device 2800 to obtain a measurement value by the graphene-based sensor of each diagnostic strip. Alternatively, when a plurality of insertion holes 2910 are included in the measurement device 2900 as shown in FIG. 29, a plurality of diagnostic strips containing a plurality of standard samples of different concentrations and a diagnostic strip of a specimen are simultaneously inserted into the insertions holes 2910 of the measurement device 2900 to obtain measurement values by the graphene-based sensors of the plurality of diagnostic strips all at once. The measurement device 2800 or 2900 identifies a change in the measurement values (e.g., change in current or voltage) by the graphene-based sensor over time for standard samples having different concentrations. In addition, the measurement device 2800 or 2900 may identify the concentration or intensity of a specimen by comparing the change in the measurement value of the standard sample for each concentration with the change in the measurement value of the specimen.

FIG. 30 is a flowchart illustrating a method of measuring a specimen according to the present disclosure.

For convenience of explanation, a method of measuring a specimen to be described with reference to FIGS. 30 to 33 will be described by assuming the method performed by the sensor measurement device 2700 of FIG. 27.

Referring to FIG. 30, the sensor measurement device 2700 applies a voltage within a predetermined range to the sensor 2710 before a sample is applied (S3000). For example, the sensor measurement device 2700 may apply a voltage between 0 and 2 V to the sensor at regular intervals and times.

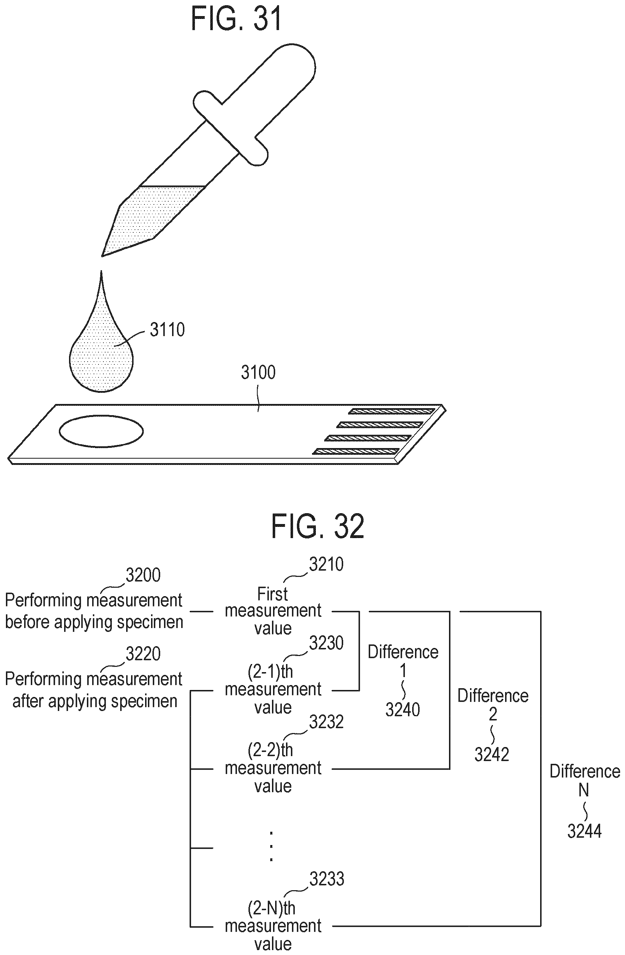

In another embodiment, the sensor measurement device 2700 may apply a voltage to the sensor 2710 after applying a buffer solution. Examples of buffer solutions include Phosphate Buffered Saline (PBS), Universal Transport Medium (UTM), PBST (PBS+Tween-20), ADA ($C_6H_{10}N_2O_5$), AMP ($C_4H_{11}NO$), BES ($C_6H_{15}NO_5S$), Bicine ($C_6H_{13}NO_4$), BIS-TRIS ($C_8H_{19}NO_5$), Bis-Tris Propane ($C_{11}H_{26}N_2O_6$), Boric Acid ($H_3BO_3$), CAPS ($C_6H_{11}NH(CH_2)_3SO_3H$), CAPSO sodium salt ($C_9H_{18}NO_4SNa$), CHES ($C_8H_{17}NSO_3$), DIPSO ($C_7H_{17}NO_6S$), DIPSO monosodium salt ($C_7H_{16}NO_6SNa$), EDTA, Glycine-HCI, HEPBS ($C_{10}H_{22}N_2O_4S$), HEPES Free Acid ($C_8H_{18}N_2O_4S$), HEPES Sodium Salt ($C_8H_{17}N_2O_4SNa$), HEPPS ($C_9H_{20}N_2O_4S$), HEPPSO Free Acid ($C_9H_{20}N_2O_5S$), HEPPSO sodium salt ($C_9H_{19}N_2O_5SNa$), MES-free acid monohydrate ($C_6H_{13}NO_4S \cdot H_2O$), MES sodium salt ($C_6H_{12}NNaO_4S$), MOPS free acid ($C_7H_{15}NO_4S$), MOPS sodium salt ($C_7H_{14}NO_4SNa$), MOPSO FREE ACID ($C_7H_{15}NO_5S$), MOPSO SODIUM SALT ($C_7H_{14}NO_5SNa$), PIPES free acid ($C_8H_{18}N_2O_6S2$), PIPES sodium salt ($C_8H_{16.5}N2\ Na_{1.5}O_6S2$), POPSO free Acid ($C_{10}H_{22}N_2O_8S_2$), POPSO disodium salt ($C_{10}H_{20}N_2O_8S_2Na_2$), Satellite free Ampicillin, SDS(Sodium dodecyl sulfate)-Urea-Tris solution, Sodium acetate, SSC, SSPE, TAE, TAPS free acid ($C_7H_{17}NO_6S$), TAPS sodium salt ($C_7H_{17}NO_6SNa$), TAPSO free acid ($C_7H_{17}NO_7S$), TAPSO sodium salt ($C_7H_{16}NO_7SNa$), TBS (TRIS-BUFFER SALINE), TBST (TBS-Tween 20), TE Buffer (Tris-EDTA), TES free acid ($C_6H_{15}NO_6S$), TG Buffer (TRIS-GLYCINE), TG-SDS Buffer (TRIS-GLYCINE-SDS), Tris ($C_4H_{11}NO_3$), Tris-HCI, Tris Hydrochloride ($C_4H_{11}NO_3 \cdot HCI$), Tris-(hydroxymethyl) propane ($C_6H_{14}O_3$), TT-SDS (Tris-Tricine-SDS buffer), TTE (Tris-TAPS-EDTA Buffer), and the like. According to embodiments, the buffer solution may be omitted. An example of a method of applying a buffer solution 3110 to the sensor 3100 is illustrated in FIG. 31.

The sensor measurement device 2700 measures resistance or current of the sensor 2710 according to the application of voltage (S3010). Hereinafter, resistance or current of the sensor 2710 measured before application of the sample is referred to as a first measurement value. The sensor measurement device 2700 measures the first measurement value for each voltage within a predetermined voltage range. For example, if a voltage between 0 and 2 V is applied at intervals of 0.1 V, the sensor measurement device 2700 identifies the plurality of first measurement values indicating resistances or currents of the sensor for each voltage such as 0.1 V, 0.2 V, ... 2 V.

A specimen is applied to the sensor 2710 (S3020). In an embodiment, if a buffer solution is applied to the sensor 2710, the specimen is applied to the sensor 2710 while the buffer solution is applied. After applying the specimen, the sensor measurement device 2700 applies a voltage within a predetermined range to the sensor (S3030). The voltage primarily applied to the sensor 2710 before application of the specimen and the voltage secondarily applied to the sensor 2710 after application of the specimen may be voltages under the same condition. For example, if the primarily applied voltage is a voltage between 0 and 2 V in units of 0.1 V, the secondly applied voltage may also be a voltage between 0 and 2 V in units of 0.1 V.

The sensor measurement device 2700 measures the resistance or current of the sensor 2710 according to the application of the voltage (S3040). Hereinafter, the resistance or current of the sensor 2710 measured after application of the specimen is referred to as a second measurement value. The sensor measurement device 2700 identifies the difference between the first measurement value before applying the specimen and the second measurement value after applying the specimen (S3050). That is, the sensor measurement device 2700 detects the difference between the first measurement value and the second measurement value for each voltage. For example, when there are a plurality of first measurement values measured by applying 0.2 V and 0.5 V before applying a specimen and a plurality of second measurement values measured by applying 0.2 V and 0.5 V after applying the specimen, the sensor measurement device 2700 compares the first measurement value for 0.2 V before applying the specimen and the second measurement value for 0.2 V after applying the specimen, and compares the first measurement value for 0.5 V before applying the specimen and the second measurement value for 0.5 V after applying the specimen. A comparison method of measurement values before and after application of the specimen will be described later with reference to FIG. 32.

As an embodiment, the sensor measurement device 2700 may output the first measurement value and the second measurement value onto a screen or transmit the same to an external device. In another embodiment, the sensor measurement device 2700 may output the difference between the first measurement value and the second measurement value onto the screen or transmit the difference to the external device.

As another embodiment, the sensor measurement device 2700 may output the maximum difference between the first measurement value and the second measurement value onto the screen or transmit the maximum difference to the external device. For example, if the difference between the first measurement value and the second measurement value for a 0.2 V voltage is A, and the difference between the first measurement value and the second measurement value for a 0.5 V voltage is B (>A), the sensor measurement device 2700 may output B having a larger difference.

As another embodiment, the sensor measurement device 2700 may repeatedly perform a process of measuring the second measurement value. For example, the sensor measurement device 2700 may input a voltage between 0 and 2 V to the sensor 2710 at regular intervals at time point t1 to obtain a plurality of second measurement values at the time point t1. The sensor measurement device 2700 may input a voltage between 0 and 2 V to the sensor 2710 at regular intervals again at time point t2 to obtain a plurality of second measurement values at the time point t2. By the method described above, the plurality of second measurement values at time point tn may be obtained. The number of times of repeatedly measuring the second measurement value and the interval (i.e., t2-t1) between repeated measurements may be variously modified according to embodiments.

The sensor measurement device 2700 may compare the plurality of second measurement values measured at time point t1 with the first measurement value previously measured, to determine the maximum difference therebetween. In addition, the sensor measurement device 2700 may compare the first measurement value with the plurality of second measurement values measured at time point t2, to determine the maximum difference therebetween. By the method described above, the maximum difference may be determined by comparing the first measurement value with the plurality of second measurement values measured at time point tn. For example, at the time point t1, the difference between the first measurement value and the second measurement value measured at 0.5 V is maximum, and at the time point t2, the difference between the first measurement value and the second measurement value measured at 0.2 V is maximum. That is, applied voltages at which the maximum difference between the first measurement value and the second measurement value appears may be different from each other at each measurement time point t1 , t2 , ...tn.

As an embodiment, the sensor measurement device 2700 may obtain a difference between the first measurement value and the second measurement value as follows.

【Equation 3】

$$\text{difference (\%)} = \frac{(\text{second measurement value} - \text{first measurement value})}{\text{first measurement value}} * 100$$

wherein, when a value measured by the sensor measurement device 2700 using the sensor 2710 is a current, the first measurement value and the second measurement value are current values of the sensor. When a value measured by the sensor measurement device 2700 using the sensor 2710 is resistance, the first measurement value and the second measurement value are the resistance values of the sensor.

In the present embodiment, the influence by the specimen on the sensor may be accurately measured by identifying the first measurement value measured before applying the specimen to the sensor 2710 and the second measurement value measured after applying the specimen to the sensor 2710. In another embodiment, the sensor measurement device 2700 may measure the specimen more accurately by using a change in the maximum difference between the first measurement value before application of the specimen and the second measurement value obtained at each time point (t1, t2, ... tn) after the second measurement value is repeatedly measured at regular time intervals.

The sensor measurement device 2700 may output the difference between the second measurement value determined at each time point and the first measurement value measured before application of the specimen to a screen or transmit the difference to an external device. In another embodiment, the sensor measurement device 2700 may output the maximum difference among differences between the second measurement value determined at each time point and the second measurement value measured before application of the specimen onto a screen or transmit the maximum difference to an external device. For example, the sensor measurement device 2700 may display the maximum difference as a number or a graph (e.g., a bar or line graph). In another embodiment, the sensor measurement device 2700 may output a result of identifying the specimen based on the change in the maximum difference onto the screen or transmit the result to the external device. As another embodiment, the sensor measurement device 2700 may output various values, such as the voltage applied at each measurement time point at which the maximum difference appears.

FIG. 32 illustrates an example of a method of measuring a specimen according to the present disclosure.

Referring to FIG. 32, the sensor measurement device 2700 applies a voltage to the sensor before application of a sample 3200 to identify a first measurement value 3210 including a current or resistance of the sensor. As an embodiment, the sensor measurement device 2700 may determine the first measurement value 3210 by applying at least one voltage to the sensor. For example, the sensor measurement device 2700 may determine the plurality of first measurement values 3210 by applying a voltage between 0 and 2 V at regular intervals.

After applying the specimen 3220, the sensor measurement device 2700 applies a voltage to the sensor to identify the second measurement value including a current or resistance of the sensor. The voltage input to the sensor after applying the specimen is the same as the voltage input to the sensor before applying the specimen. The sensor measurement device 2700 may repeatedly perform the process of measuring the second measurement value. For example, the sensor measurement device 2700 determines the (2-1)th measurement value 3230 by applying a voltage at time point t1. In addition, the sensor measurement device 2700 determines the (2-2)th measurement value 3232 to (2-N)th measurement value 3234 at time points t2 to tn, respectively.

The sensor measurement device 2700 determines the difference between the first measurement value 3210 and the second measurement value for each voltage. For example, it is assumed that the first measurement value 3210 and the second measurement value are all measured with respect to voltages V1, V2, and V3. The sensor measurement device 2700 compares the first measurement value 3210 and the second measurement value at time point t1 (i.e., the (2-1)th measurement value 3230) for each voltage. If the difference between the (2-1)th measurement value 3230 and the first measurement value 3210 measured by applying V2 at time point t1 is the maximum, the sensor measurement device 2700 determines the difference between the (2-1)th measurement value 3230 and the first measurement value 3210 at V2 as the maximum difference 3240 at time point t1. By using the method described above, the maximum difference 3242 is determined by comparing the voltage-specific difference between the first measurement value 3210 and the (2-2)th measurement value 3232 at time point t2, and the maximum difference 3244 is determined by comparing the voltage-specific difference between the first measurement value 3210 and the (2-N)th measurement value 3234 at time point tn.

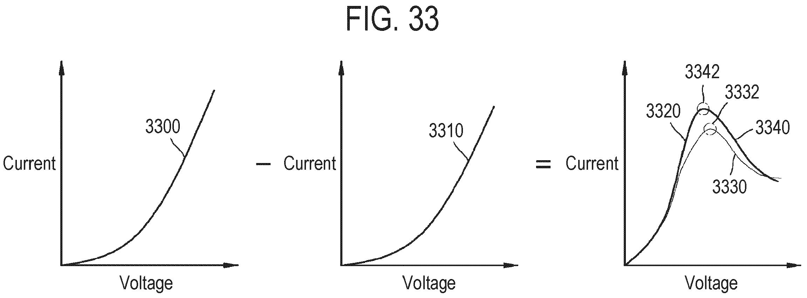

FIG. 33 illustrates an example of measurement results that can be referred to in various embodiments of the present disclosure.

FIG. 33 illustrates a first graph 3300 showing a result of measuring a current by applying a voltage within a predetermined range to the sensor before applying a sample, and a second graph 3310 showing a result of measuring a current by applying a voltage within a predetermined range to the sensor after applying the specimen. The graphs 3300 and 3310 show sensor measurement values according to voltages at a regular interval, which are connected in the form of curves. In addition, the graph of the present embodiment is only an example to facilitate understanding, and sensor measurement results may be displayed in various types of graphs or numbers.

As an embodiment, repeating the process of determining the second measurement value as shown in FIG. 32 may produce a plurality of second graphs 3310, i.e., a (2-1)th graph representing the (2-1)th measurement value 3230 measured by the sensor at time point t1, a (2-2)th graph representing the (2-2)th measurement value 3232 measured by the sensor at time point t2, and a (2-N)th graph representing the (2-N)th measurement value 3234 measured by the sensor at time point tn. However, in the present embodiment, only one graph is shown for convenience of explanation.

The sensor measurement device 2700 may determine the difference between the sensor measurement values for each voltage in the first graph and the second graph by using Equation 3. The difference between the measurement values is not limited to Equation 3, and may be obtained in various ways. The difference between the first graph 3300 and the second graph 3310 is shown in a third graph 3320. For example, referring to FIG. 32, the graph 3320 representing the difference between the (2-1)th measurement value 3230 and the first measurement value 3210 and a graph 3330 representing the difference between the (2-2)th measurement value 3232 and the first measurement value 3232 are shown in the third graph. The specimen may be identified based on the change in position of the maximum value points 3332 and 3342 in the two graphs 3330 and 3340.

FIG. 34 illustrates an example of using a measurement device according to the present disclosure.

Referring to FIG. 34, the measurement device 3410 may include a communication unit that may be used by connecting to a smartphone 3400. For example, the measurement device 3410 may be connected to the smartphone through an earphone terminal, a charging terminal, or Bluetooth. Various examples of the measurement device 3410 are illustrated in FIGS. 17-29.

The smartphone 3400 may display a voltage value received from the measurement device 3410 on a screen or transmit the voltage value to an external device. In another embodiment, the smartphone 3400 may display a result obtained by analyzing the voltage value received from the measurement device 3410 on the screen or transmit the result to the external device. For example, software implementing an analysis method of FIGS. 35 to 36 to be described below may exist in the smartphone 3400.

In another embodiment, information capable of identifying a measurement device, such as a QR code or a barcode, may exist on one side of the measurement device 3410. When a QR code exists in the measurement device 3410, the smartphone 3400 may recognize a QR code through a camera, and store the value of the QR code and the voltage value (or analysis result) of the measurement device 3410 therein or send the same to an external device.

FIG. 35 illustrates an example of a method of analyzing measurement results according to the present disclosure.

Referring to FIG. 35, a sensor array 3500 outputs measurement values 3510 (e.g., current or voltage) of a plurality of graphene-based sensors. The structures of the sensor array 3500 are illustrated in FIGS. 1-15. As another embodiment, an output unit configured to convert an output current into a voltage may be provided at an output terminal of the sensor array 3500. However, hereinafter, for convenience of description, it is assumed that the measurement value output from the sensor array 3500 is adjusted to a voltage value within a predetermined range through the output unit. That is, all ranges of measurement values are normalized to values within a predetermined range.

The plurality of measurement values 3510 output from the sensor array 3500 are input to the artificial neural network 3520. The artificial neural network 3520 may be implemented using various deep learning models of the related art, such as a convolutional neural network (CNN). The artificial neural network 3520 is trained in advance using training data. For example, the artificial neural network 3520 may be trained by a supervised learning method using learning data in which a plurality of measurement values 3510 obtained by measuring a standard sample by using the sensor array are labeled using preidentified standard sample information (e.g., wavelength/intensity of light, type/amount of biomolecules, type/amount of gas molecules, strength of pressure, etc.). A learning method of a regression analysis model may be mainly used as an example of the supervised learning method. When the artificial neural network 3520 that has been trained by the method described above receives the plurality of measurement values 3510 measured by the sensor array, the artificial neural network 3520 outputs the analysis result 3530 (e.g., wavelength/intensity of light, type/amount of biomolecules, type/amount, intensity of pressure, etc.). Various analysis methods are described in the following.

As a first embodiment of the analysis method, a method of detecting a wavelength or intensity of light by using the sensor array 3500 and the artificial neural network 3520 will be described first. Reaction layers of the plurality of graphene-based sensors of the sensor array 3500 include different quantum dot materials that sense light of different wavelengths. For example, the reaction layers of the plurality of graphene-based sensors constituting the sensor array 3500 may be formed of quantum dots that respond to R, G, and B. When the artificial neural network 3520, which has been trained in advance, receives the plurality of measurement values 3510 of the sensor array, the artificial neural network 3520 outputs a wavelength in the visible ray region as an analysis result. As another example, the reaction layers of the plurality of graphene-based sensors may be formed of quantum dots that sense infrared rays of different wavelength bands to detect wavelengths in the infrared region. In this case, the amount of blood glucose may be measured through infrared sensing of the skin. As another example, the reaction layer of each graphene-based sensor of the sensor array 3500 may be formed of different quantum dots capable of detecting different wavelength bands in the UV-IR region to analyze the wavelength of a signal.

As a second embodiment of the analysis method, the type and amount of biomolecules may be detected using the sensor array 3500 and the artificial neural network 3520. The reaction layers of the plurality of graphene-based sensors of the sensor array 3500 may include biomolecules (e.g., DNA, RNA, antigens, antibodies, enzymes, etc.) having different degrees of reaction. For example, the degree to which a first antibody of the reaction layer of the first graphene-based sensor of the sensor array 3500 reacts to various viruses (e.g., SARS-CoV-1, SARS-CoV-2, MERS-Cov, etc.) and the degree to which a second antibody of the reaction layer of the second graphene-based sensor reacts to various viruses (i.e., the signal of the measurement value) may be different from each other. In other words, the degree to which the first antibody reacts to a first virus is r1, the degree to which the second antibody reacts to a second virus is r2, and the degrees to which the second antibody reacts to the first virus and the second virus are r3 and r4, respectively, which can be different from one another.

When the sensor array 3500 outputs the plurality of measurement values 3510 of a specimen, the artificial neural network 3520 outputs the type/amount of a virus as an analysis result. To this end, the artificial neural network 3520 may be pretrained using learning data in which the measurement values 3510 of the sensor array 3500 for various types of viruses are labeled using the types and/or amounts of viruses. The reaction layer of each graphene-based sensor may be formed of antibodies having different degrees of reaction to various viruses, to detect the type and amount of a specimen according to the reaction degree of each antibody. Therefore, the sensor array 3500 can detect a greater number of viruses than the number of graphene-based sensors included therein. In addition, if the reaction degree of each antibody in the reaction layer of the graphene-based sensor is different with respect to a new virus, the existing sensor array 3500 is used as it is without having to make the reaction layer again and the artificial neural network is trained using learning data for the new virus so as to detect the new virus.

As a third embodiment of the analysis method, a method of diagnosing a disease by using the sensor array 3500 and the artificial neural network 3520 will be described. Reaction layers are formed in the plurality of graphene-based sensors of the sensor array 3500 by using various materials, such as DNA, RNA, antigens, antibodies, and enzymes. For example, the first graphene-based sensor of the sensor array 3500 may include a reaction layer of a material capable of detecting DNA, and a second graphene-based sensor may include a reaction layer of a material capable of detecting an enzyme. The artificial neural network 3520 predicts and outputs a disease upon receiving a plurality of measurement values 3510 by the sensor array 3500. That is, a specific disease may be diagnosed through a combination of various measurement values. To this end, the artificial neural network 3520 may be pretrained by learning data in which a plurality of measurement values obtained by inputting a specimen capable of diagnosing a specific disease to the sensor array 3500 are labeled using the names of diseases.

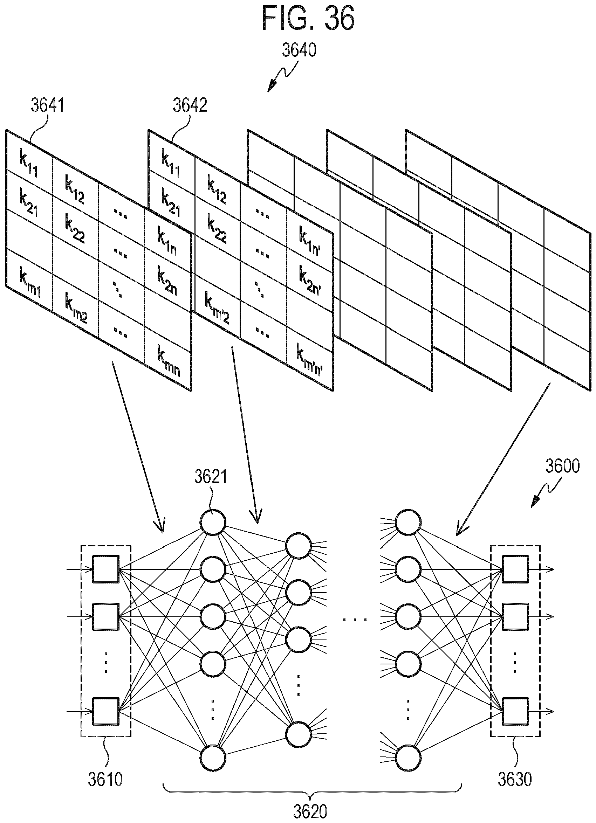

FIG. 36 illustrates an example of an artificial neural network that may be referenced in various embodiments of the present disclosure.

Referring to FIG. 36, an artificial neural network 3600 includes an input layer 3610, one or more hidden layers 3620, and an output layer 3630. The one or more hidden layers 3620 include one or more network nodes 3621. The one or more network nodes 3621 have a connection relationship with each other by simulating synaptic activities of neurons in which human neurons exchange signals through synapses. For example, in the artificial neural network 3600, the one or more network nodes 3621 are located in layers (e.g., hidden layers) of different depths and exchange data according to a convolution connection relationship. In addition, network nodes having various connection relationships (e.g., recurrent, etc.) are included in the artificial neural network 3600. The connection relationship between these network nodes may be defined as mapping tables 3641 and 3642 for each layer of the hidden layers. The set of mapping tables 3641 and 3642 may be simply referred to as a mapping table set 3640.

The mapping table set 3640 is determined through learning of the artificial neural network 3600 described above. In an embodiment, the mapping table set 3640 may be implemented as various types of internal circuits. An internal circuit implemented as hardware may be included in the measurement devices 2500 and 2600 of FIGS. 28 and 29. In another embodiment, the mapping table set 3640 may be implemented as various types of computer programs. A computer program implemented as software may be included in the measurement devices 2500 and 2600 of FIGS. 28 and 29. Accordingly, the artificial neural network 3600 receives a plurality of measurement values by the sensor array and outputs an analysis result according to an operation determined in the mapping table set 3640 (e.g., wavelength/intensity of light, type/amount of biomolecules, type/amount of gas molecules, strength of pressure, etc.).

In the flowcharts of the present disclosure, the operations of a method or algorithm are described in a sequential order, but may be performed in any combinable order, in addition to being performed sequentially. The description of flowcharts in this disclosure does not exclude application of changes or modifications to methods or algorithms, and does not imply that any operation is necessary or desirable. In an embodiment, at least some of the operations may be performed in parallel, iteratively, or heuristically. In another embodiment, at least one operation may be omitted or other operations may be added.

Various embodiments of the present disclosure may be implemented as software in a machine-readable storage medium (MRSM) that can be read by a computing device. The software may be software for implementing various embodiments of the present disclosure. The software can be inferred from various embodiments of the present disclosure by programmers skilled in the art. For example, the software may be a computer program containing instructions that can be read by a computing device. The computing device is a device capable of operating according to instructions called from a storage medium, and may be referred to interchangeably with, for example, an electronic device. In an embodiment, a processor of the computing device may execute an invoked command, causing components of the computing device to perform functions corresponding to the command. The storage medium may refer to any type of recording medium in which information readable by a device is stored. The storage medium may include, for example, ROM, RAM, CD-ROM, magnetic tape, floppy disk, or optical information storage device. In an embodiment, the storage medium can be distributed to computer systems which are connected through a network. In this case, the software may be distributed, stored, and executed in the computer systems or the like. In another embodiment, the storage medium may be a non-transitory storage medium. A non-transitory storage medium refers to a medium that exists regardless of whether information is stored semi-permanently or temporarily, and does not include a transitory signal.

Although the technical idea according to the present disclosure has been described by various embodiments above, the technical idea according to the present disclosure includes various substitutions, modifications, and changes that can be made within the scope understandable by those of ordinary skill in the art to which the present disclosure belongs. In addition, it should be noted that such substitutions, modifications and changes are intended to fall within the scope of the appended claims.

**Claims**

1. A graphene-based sensor comprising:

   a substrate;
   a doped region formed by doping a partial region of the substrate with impurities;
   an insulator layer stacked on the substrate except for a portion of the doped region;
   a graphene layer stacked on the doped region;
   a first electrode connected to the graphene layer; and
   a second electrode connected to the doped region.

2. The graphene-based sensor of claim 1, wherein the doped region comprises:

   a first doped region doped to have a first concentration; and
   a second doped region doped to have a second concentration,
   wherein the first concentration is equal to or less than the second concentration,
   wherein the graphene layer is connected to the first doped region, and
   wherein the second electrode is connected to the second doped region.

3. The graphene-based sensor of claim 1, wherein the first electrode surrounds a periphery of the graphene layer.

4. The graphene-based sensor of claim 1, wherein the second electrode is positioned under the substrate to be opposite to the graphene layer.

5. The graphene-based sensor of claim 1, further comprising one or more via electrodes passing through the insulator layer and the substrate from a position spaced apart from the first electrode,
   wherein the second electrode is connected to the one or more via electrodes.

6. The graphene-based sensor of claim 1, wherein the second electrode passes through the insulator layer to be connected to the doped region.

7. The graphene-based sensor of claim 1, further comprising a third electrode spaced apart from the first electrode and in contact with the graphene layer.

8. The graphene-based sensor of claim 1, further comprising:

   a storage unit formed by etching the substrate to have a first depth and a first width; and
   a channel unit formed by etching the insulator layer to have a second depth and a second width and configured to connect the storage unit and the graphene layer to each other,
   wherein the second depth and the second width are smaller than the first depth and the first width, respectively.

9. The graphene-based sensor of claim 1, wherein a plurality of doped regions are formed on the substrate to be spaced apart from each other, and
   wherein the insulator layer is stacked such that the plurality of doped regions are exposed.

10. The graphene-based sensor of claim 9, wherein the graphene layer is stacked to correspond to the plurality of doped regions,

    wherein the graphene-based sensor comprises a plurality of first electrodes corresponding to the plurality of doped regions, respectively, and
    wherein the second electrode is connected in common to the plurality of doped regions.

11. The graphene-based sensor of claim 9, wherein the graphene layer is stacked on the plurality of doped regions,

   wherein the graphene-based sensor comprises a plurality of second electrodes connected to the plurality of doped regions, respectively, and
   wherein the first electrode is connected in common to the plurality of doped regions.

12. The graphene-based sensor of claim 10 or 11, further comprising a multiplexer configured to output a value measured through the graphene layer on the plurality of doped regions.

13. The graphene-based sensor of claim 1, further comprising a reaction layer located on a surface of the graphene layer and comprising a material that induces electric charges in the graphene layer.

14. A graphene-based sensor comprising:

   a substrate;
   a two-dimensional semiconductor layer stacked on the substrate;
   a graphene layer stacked on the two-dimensional semiconductor layer;
   a first electrode stacked in contact with the two-dimensional semiconductor layer; and
   a second electrode stacked in contact with the graphene layer.

15. The graphene-based sensor of claim 14, further comprising a reaction layer located on a surface of the graphene layer and comprising a material that induces electric charges in the graphene layer.

16. The graphene-based sensor of claim 14, wherein a plurality of two-dimensional semiconductor layers are disposed on the substrate to be spaced apart from each other,

   wherein the graphene layer is stacked on the plurality of two-dimensional semiconductor layers, and
   wherein a plurality of first electrodes are disposed on the plurality of two-dimensional semiconductor layers, respectively.

17. The graphene-based sensor of claim 16, wherein a two-dimensional material constituting the plurality of two-dimensional semiconductor layers comprises a portion and another portion different from each other.

18. The graphene-based sensor of claim 16, wherein the plurality of two-dimensional semiconductor layers are disposed in a first direction, and
   wherein the graphene layer is disposed in a second direction perpendicular to the first direction.

19. The graphene-based sensor of claim 14, further comprising a third electrode spaced apart from the first electrode and stacked in contact with the two-dimensional semiconductor layer.

20. The graphene-based sensor of claim 14, further comprising a fourth electrode spaced apart from the second electrode and stacked in contact with the graphene layer.

21. The graphene-based sensor of claim 14, wherein a plurality of two-dimensional semiconductor layers are radially arranged,

   wherein the graphene layer is disposed across the plurality of two-dimensional semiconductor layers to have a circular band shape,
   wherein the graphene-based sensor further comprises a third electrode connected in common to a plurality of two-dimensional semiconductor layers, and
   wherein the plurality of first electrodes are connected to the plurality of two-dimensional semiconductor layers, respectively.

22. A measurement device comprising:

   a graphene-based sensor in which a graphene layer is stacked on a doped region formed on a substrate or on a two-dimensional semiconductor layer stacked on the substrate; and
   an output unit configured to convert an output current of the graphene-based sensor into a voltage and output the voltage.

23. The measurement device of claim 22, wherein the output unit comprises:

a preamplification unit configured to convert the output current of the graphene-based sensor into a voltage and output the voltage; and
a feedback unit configured to perform adjustment such that the output voltage of the preamplification unit is in a predetermined range.

24. The measurement device of claim 22, further comprising:

a display unit configured to display an output voltage of the output unit; and
a communication unit configured to transmit the output voltage of the output unit to the outside.

25. The measurement device of claim 22, further comprising:

a sensor array in which the graphene-based sensor is arranged in one or two dimensions; and
a multiplexer connected to a plurality of graphene-based sensors constituting the sensor array,
wherein the output unit is configured to selectively receive an output current of each graphene-based sensor through the multiplexer.

26. The measurement device of claim 22, further comprising an internal circuit including a mapping table set corresponding to an artificial neural network configured to receive a measurement value obtained by a reaction between a specimen and a material of a reaction layer of the graphene-based sensor and output an analysis value.

27. The measurement device of claim 22, further comprising:

a voltage application unit configured to apply a voltage within a predetermined range to the graphene-based sensor; and
a measurement unit configured to detect a first measurement value of resistance or current of the graphene-based sensor according to a voltage applied before application of a specimen, and detect and output a second measurement value of resistance or current of the graphene-based sensor according to a voltage applied after application of the specimen.

28. The measurement device of claim 27, wherein the measurement unit outputs a result value comprising a maximum difference among voltage-specific differences between the first measurement value and the second measurement value.

29. The measurement device of claim 27, wherein the measurement unit repeats a process of measuring the second measurement value at a regular time interval, and outputs a second measurement value of resistance or current of a sensor according to a voltage applied whenever a repetition is performed.

30. The measurement device of claim 29, wherein the measurement unit detects and outputs a change in a maximum difference between the first measurement value and the second measurement value whenever the repetition is performed.

31. An analysis method using a sensor array comprising a plurality of sensors in which a graphene layer is stacked on a two-dimensional semiconductor or on a semiconductor region doped on a substrate, the method comprising:

receiving a plurality of measurement values from a plurality of graphene-based sensors of the sensor array; and
receiving the plurality of measurement values and obtaining an analysis result, by an artificial neural network, using an arithmetic operation determined in a mapping table set.

32. The analysis method of claim 31, wherein a material of a reaction layer applied on the graphene layer of the plurality of graphene-based sensors comprises a portion and another portion different from each other.

33. The analysis method of claim 31, wherein a material of a reaction layer of the plurality of graphene-based sensors comprises at least one of a quantum dot, a biomolecule, a gas-responsive molecule, or a pressure-responsive

structure.

FIG. 1A

FIG. 1B

FIG. 1C

FIG. 1D

FIG. 2A

FIG. 2B

# FIG. 2C

230   220

250   255
260

210
200

A   A'

# FIG. 2D

220   240

260 { 250
        255

210
200

B'   B

# FIG. 3A

370   390

380
320
330
310

370

# FIG. 3B

# FIG. 4A

## FIG. 4B

430 480 420 432 434

410

400

450 455 440
460

## FIG. 5

540 520 560 530 550 500

510

## FIG. 6A

## FIG. 6B

# FIG. 7A

730  B  720

A1

A2

A  A3  A'

740  742

780

710

B'

# FIG. 7B

740  780  720  742

710

700

A  A'

750  755

760

# FIG. 7C

732 — 720 — 730
780 — 710
710
700
B' B
750 755
760

# FIG. 7D

732 — 780 — 720 — 730
710
700
B' B
750 755
760

# FIG. 8A

# FIG. 8B

# FIG. 8C

# FIG. 8D

## FIG. 9A

## FIG. 9B

## FIG. 10A

1032

Address

A1

A2

A3

1020

A

1030

1060

1050

Output unit

A'

Data

1010

## FIG. 10B

1030

1080

1020

1032

1050

1072

1074

1010

1000

Output unit

A

A'

1050

1055

1060

FIG. 11A

FIG. 11B

EP 4 556 900 A1

## FIG. 12

## FIG. 13A

## FIG. 13B

## FIG. 14

## FIG. 15

## FIG. 16A

$$R \sim e^{\sqrt{\Delta Q}}$$

Graphene-based sensor

## FIG. 16B

Linear Scale

$$R \sim \frac{\Delta Q}{Q}$$

Current

1660

1650

Voltage

Transistor-based sensor

FIG. 17

FIG. 18

## FIG. 19

EP 4 556 900 A1

# FIG. 20

FIG. 21

## FIG. 22

# FIG. 23

# FIG. 24

EP 4 556 900 A1

# FIG. 25

2500  2510  2520  2530

Pre-Amplifier

Address Line

MUX

Gain

G  G  G  G

Set Point

Control Circuit

Feedback Circuit

Sensor Chip

Type III Circuit Board

EP 4 556 900 A1

# FIG. 26

2600  2610  2620  2630

Pre-Amplifier

Address Line

MUX

Gain

G  G  G  G

Set Point

Control Circuit

Feedback Circuit

Sensor Chip

Type III Circuit Board

EP 4 556 900 A1

## FIG. 27

Sensor measurement device — 2700
2702 — Voltage application unit
2704 — Measurement unit
2710 — Sensor

## FIG. 28

2800
2810

# FIG. 29

# FIG. 30

Start

Applying voltage — S3000

Measuring resistance and/or current of sensor — S3010

Applying specimen — S3020

Applying voltage — S3030

Measuring resistance and/or current of sensor — S3040

Identifying difference between measurement value before applying specimen and measurement value after applying specimen — S3050

End

# FIG. 31

3110

3100

# FIG. 32

3200
Performing measurement
before applying specimen

3210
First
measurement
value

3220
Performing measurement
after applying specimen

3230
(2-1)th
measurement
value

Difference
1

3240

3232
(2-2)th
measurement
value

Difference
2

3242

Difference
N

3244

3233
(2-N)th
measurement
value

# FIG. 33

# FIG. 34

3410 — Measurement device

3400 —

3400 —

Measurement device — 3410

# FIG. 35

3500 — Sensor array

3510 — First measurement value
Second measurement value
⋮
Nth measurement value

3520 — Artificial neural network

3530 — Analysis result

# FIG. 36

# INTERNATIONAL SEARCH REPORT

International application No.

**PCT/KR2023/009811**

## A. CLASSIFICATION OF SUBJECT MATTER

**G01N 27/48**(2006.01)i; **G01N 27/327**(2006.01)i; **G01N 27/12**(2006.01)i; **H10N 30/80**(2023.01)i; **H10N 30/30**(2023.01)i; **H01L 31/0264**(2006.01)i; **H01L 31/02**(2006.01)i; **H01L 31/0224**(2006.01)i; **H01L 31/028**(2006.01)i; **H01L 31/102**(2006.01)i

According to International Patent Classification (IPC) or to both national classification and IPC

## B. FIELDS SEARCHED

Minimum documentation searched (classification system followed by classification symbols)

G01N 27/48(2006.01); A61B 5/00(2006.01); B82Y 30/00(2011.01); G01N 21/17(2006.01); G01N 27/12(2006.01); G01N 27/30(2006.01); G01N 27/411(2006.01); G01N 27/414(2006.01); G01W 1/02(2006.01); H01L 29/16(2006.01); H01L 29/786(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 기판(substrate), 도핑(doping), 그래핀(graphene), 센서(sensor), 전극(electrode)

## C. DOCUMENTS CONSIDERED TO BE RELEVANT

| Category* | Citation of document, with indication, where appropriate, of the relevant passages | Relevant to claim No. |
|---|---|---|
| Y | US 2014-0260547 A1 (THE REGENTS OF THE UNIVERSITY OF CALIFORNIA) 18 September 2014 (2014-09-18)<br>See paragraph [0037], claims 1 and 4 and figures 2 and 7. | 1-13,22-30 |
| Y | KR 10-2019-0094646 A (KOREA UNIVERSITY RESEARCH AND BUSINESS FOUNDATION) 14 August 2019 (2019-08-14)<br>See paragraphs [0030], [0036] and [0046] and figure 1. | 1-13 |
| Y | KR 10-2022-0026358 A (GRIT8 CO., LTD.) 04 March 2022 (2022-03-04)<br>See paragraphs [0023]-[0035], [0047] and [0048] and figures 1 and 2. | 12,22-30 |
| X | KR 10-2021-0141124 A (RESEARCH & BUSINESS FOUNDATION SUNGKYUNKWAN UNIVERSITY) 23 November 2021 (2021-11-23)<br>See paragraphs [0049]-[0054], [0061] and [0068] and figures 1-5. | 14,15 |
| Y |  | 16-21,31-33 |

☑ Further documents are listed in the continuation of Box C.  ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **17 October 2023** | **17 October 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 556 900 A1**

## INTERNATIONAL SEARCH REPORT

International application No.

**PCT/KR2023/009811**

### C. DOCUMENTS CONSIDERED TO BE RELEVANT

| Category* | Citation of document, with indication, where appropriate, of the relevant passages | Relevant to claim No. |
|---|---|---|
| Y | US 2015-0194536 A1 (INTERNATIONAL BUSINESS MACHINES CORPORATION) 09 July 2015 (2015-07-09)<br>See paragraph [0041] and figure 1. | 16-18 |
| Y | KR 10-2022-0082410 A (AJOU UNIVERSITY INDUSTRY-ACADEMIC COOPERATION FOUNDATION) 17 June 2022 (2022-06-17)<br>See paragraphs [0054] and [0055] and figure 1. | 19-21 |
| Y | KR 10-2021-0118640 A (ELECTRONICS AND TELECOMMUNICATIONS RESEARCH INSTITUTE) 01 October 2021 (2021-10-01)<br>See paragraphs [0030] and [0031] and figure 1. | 26,31-33 |

Form PCT/ISA/210 (second sheet) (July 2022)

58

**INTERNATIONAL SEARCH REPORT**
Information on patent family members

International application No.

**PCT/KR2023/009811**

| Patent document cited in search report | | | Publication date (day/month/year) | Patent family member(s) | | | Publication date (day/month/year) |
|---|---|---|---|---|---|---|---|
| US | 2014-0260547 | A1 | 18 September 2014 | US | 9678036 | B2 | 13 June 2017 |
| KR | 10-2019-0094646 | A | 14 August 2019 | US | 2019-0242827 | A1 | 08 August 2019 |
| KR | 10-2022-0026358 | A | 04 March 2022 | | None | | |
| KR | 10-2021-0141124 | A | 23 November 2021 | | None | | |
| US | 2015-0194536 | A1 | 09 July 2015 | CN | 103329244 | A | 25 September 2013 |
| | | | | CN | 103329244 | B | 01 June 2016 |
| | | | | DE | 112011103809 | B4 | 09 July 2020 |
| | | | | DE | 112011103809 | T5 | 14 August 2013 |
| | | | | GB | 2500542 | A | 25 September 2013 |
| | | | | GB | 2500542 | B | 20 August 2014 |
| | | | | US | 2012-0175594 | A1 | 12 July 2012 |
| | | | | US | 2013-0001519 | A1 | 03 January 2013 |
| | | | | US | 2015-0325672 | A1 | 12 November 2015 |
| | | | | US | 9076873 | B2 | 07 July 2015 |
| | | | | US | 9082856 | B2 | 14 July 2015 |
| | | | | US | 9306028 | B2 | 05 April 2016 |
| | | | | US | 9466686 | B2 | 11 October 2016 |
| | | | | WO | 2012-094154 | A1 | 12 July 2012 |
| KR | 10-2022-0082410 | A | 17 June 2022 | | None | | |
| KR | 10-2021-0118640 | A | 01 October 2021 | | None | | |

Form PCT/ISA/210 (patent family annex) (July 2022)